# EUROPEAN PATENT APPLICATION

(11) **EP 1 814 369 A1**
(43) Date of publication of application: **01.08.2007**
(21) Application number: 05787761.5
(22) Date of filing: 28.09.2005
(51) Int. Cl.: H05K 3/00, B65H 37/04

(54) **LONG FILM CIRCUIT BOARD, AND PRODUCTION METHOD AND PRODUCTION DEVICE THEREFOR**

(30) Priority: 01.10.2004 JP 2004289707; 28.04.2005 JP 2005131248
(71) Applicant: TORAY INDUSTRIES, INC., Tokyo 103-8666 (JP)
(72) Inventor: TANIMURA, Yasuaki, 5200842 (JP); AKAMATSU, Takayoshi, 5200837 (JP); OKUYAMA, Futoshi, 5202144 (JP); KUROKI, Nobuyuki, 5200845 (JP)
(74) Representative: Kador & Partner
(86) International application number: PCT/JP2005/017786
(87) International publication number: WO 2006/038496

(57) **Abstract**

When a number of flexible circuit boards where a circuit pattern is formed on at least one surface are connected to each other so as to form a tape-style flexible circuit board, a space for conveyance is provided in the pairs of end portions facing each other of the flexible circuit boards, at least a portion of the space for conveyance protrudes in the direction parallel to the direction of conveyance of the flexible circuit boards, and the protruding space for conveyance overlaps and is fixed to a space for conveyance of an adjacent flexible circuit board.

## Description

### TECHNICAL FIELD

The present invention relates to a tape-style flexible circuit board using a flexible film which is appropriate as a circuit board having a highly precise circuit pattern, and a manufacturing method and a manufacturing apparatus for the same.

### BACKGROUND ART

Together with the reduction in weight and the miniaturization of electronic products, an increase in the precision of patterning of printed circuit boards has been required. Flexible circuit boards can be bent, making three-dimensional wiring possible, and therefore, appropriate for the miniaturization of electronic products, and thus, demands have been expanded. In accordance with a COF (chip on flex) technology which is used for connecting an IC to a liquid crystal display panel, a tape-style flexible circuit board having a relatively narrow width and made of polyimide is processed. As a result, the finest pattern for a resin substrate can be gained. However, the progress of miniaturization is approaching the limit.

Miniaturization has indices where one is indicated by the width of the lines which form the circuit pattern or the width of the spaces between the lines, and the other is indicated by the locations in the circuit pattern on a board. Though there are techniques to further miniaturize the line width and the space width, the precision of the locations, which is the latter index, relates to the positioning between the electrode pads of electronic parts and the circuit pattern when electronic parts, such as IC's, are bonded to a circuit board, and thus, it is becoming harder to cope with the required precision as the number of pins of IC's increases.

In recent years, it has been proposed to form a very fine circuit pattern by laminating a flexible circuit board onto a reinforcing plate, maintaining precision of the dimensions (see Patent Document 1). In accordance with this method, a flexible circuit board is laminated onto a reinforcing plate when being processed, and thereby, the influence of temperature and moisture during processing as well as distortion during conveyance can be taken away. As a result, a flexible circuit board having low distortion can be provided, and the precision of dimensions can be highly maintained even after being peeled from the reinforcing plate.

However, the above described proposal handles mainly sheet-style reinforcing plates, and the flexible circuit boards on which a circuit pattern is formed are also sheets. Meanwhile, in accordance with a conventional COF technology, flexible circuit boards on which a circuit pattern is formed are, in many cases, handled in such a manner that tape-style flexible circuit boards are handled reel-to-reel when electronic parts are connected, tests are carried out, or LCD panels are connected, though flexible circuit boards in sheet form are handled in some cases. Accordingly, a problem arises where the range to which the above described proposal is applied is limited. Therefore, though there is a possibility that sheet-style flexible circuit boards are connected to form a tape-style flexible circuit board so that the range of application can be expanded, it is difficult to convey and position flexible circuit boards in sheet form having a thickness of, for example, several tens of µm in a state where they are not laminated onto a reinforcing plate, and therefore, the automation of the connection step is difficult, and furthermore, the automation of the subsequent process of the tape-style flexible circuit board is also difficult.

In addition, even in the case where a tape-style flexible circuit board is handled, in order to achieve a sequential operation of a circuit board manufacturing apparatus using this, it is necessary to connect the rear-end of a flexible circuit board which forms a leading tape-style flexible circuit board to the leading end of a flexible circuit board which forms another tape-style flexible circuit board. In this case, the rear-end of a flexible circuit board which forms a leading tape-style flexible circuit board is connected to the leading end of a flexible circuit board which forms the following tape-style flexible circuit board by means of an adhesive tape. At this time, in order to increase the strength of connection so that distortions or damages can be prevented from occurring in the subsequent processing step, a recognition mark is provided to the connected portion, and the connected portion is skipped from heating in order to prevent the adhesive tape from being peeled due to heat in the heating step according to a method that has been proposed (see Patent Document 2).

In accordance with this method, however, a problem arises where the portions of the flexible circuit boards which are the front or the back of the connection portion in addition to the connection portions end up being wasted. In addition, in the case where IC's are bonded to the tape-style flexible circuit board, IC's are connected to circuit patterns while intermittently feeding the tape-style flexible circuit board on which circuit patterns are formed, usually at equal intervals. When the portions of the flexible circuit boards which are the front or the back of the connection portion cannot be used as described above, however, the tape-style flexible circuit board is fed without bonding an IC to the circuit patterns on the front or the back of the connection portion. That is to say, time loss occurs due to feeding without bonding in the step of bonding an IC to the tape-style flexible circuit board.

The following method has been proposed as the method for connecting the leading tape-style flexible circuit board to the following tape-style flexible circuit board. That is to say, a method is provided according to which a protrusion and a recess are respectively created in the flexible circuit board which forms the leading tape-style flexible circuit board and the flexible circuit board which forms the following tape-style flexible circuit board, and they are confronted each other in such a manner that the protrusion is fitted into the recess and tape up so as to cover the protrusion and the recess (see Patent Document 3). In accordance with this method, however, the portions of the flexible circuit boards in the connection portion end up being wasted in the same manner as in the above described method.

Furthermore, connections as described above are required in the case where defects collectively occur in the group of circuit patterns which are formed on the tape-style flexible circuit board. In this case, the unnecessary portion is removed through cutting, and one end of the divided tape-style flexible circuit board is connected to the other end, and thereby, the efficiency of the subsequent process can be prevented from decreasing. At this time, the two ends facing the removed portion are confronted each other and taped together with a ladder-style member for connection, and thus, are fixed, and furthermore, feeding holes are created in the member for connection, and at the same time, the member for connection and the tape-style flexible circuit board are caulked together so that the strength of the connection is increased according to a method that has been proposed (see Patent Document 4).

In accordance with this method, however, ladder-style members for connection, such as those made of a thermoplastic film, are required in addition to the tape-style flexible circuit board. Furthermore, in accordance with this method, such a thermoplastic film is used, and therefore, it is difficult to implement the method in the case where the method includes a heating step, such as resin molding or solder reflow, in the subsequent step. That is to say, it is difficult to utilize both the ease of caulking due to a change in form through heating and the resistance to heat in the subsequent step.
Patent Document 1: Pamphlet of International Unexamined Patent Publication No. 03/009657 (page 2)
Patent Document 2: Japanese Unexamined Patent Publication 2000-25709 (paragraphs 46 and 80)
Patent Document 3: Japanese Unexamined Patent Publication 2005-45233 (paragraph 16)
Patent Document 4: Japanese Unexamined Patent Publication H4 (1992)-127549 (page 2)

### DISCLOSURE OF THE INVENTION

### Problem to be Solved by the Invention

In view of the above described problems, an object of the present invention is to provide a manufacturing method and a manufacturing apparatus for a tape-style flexible circuit board according to which flexible circuit boards which are handled as sheets can be handled using reel-to-reel equipment to its maximum as well as a tape-style flexible circuit board which is gained using these. In addition, another object of the present invention is to provide a tape-style flexible circuit board which makes it possible to reduce the loss of flexible circuit boards when connected and loss in time for bonding an IC as well as a manufacturing method and a manufacturing apparatus for the same.

### Means for Solving the Problem

In order to solve the above described problems, the present invention is characterized by the following (1) to (20).
(1) A tape-style flexible circuit board, wherein a number of flexible circuit boards where a circuit pattern is formed on at least one surface are connected to each other, the flexible circuit boards have spaces for conveyance in a pair of end portions facing each other, at least a portion of the spaces for conveyance protrudes in the direction parallel to the direction of conveyance of the flexible circuit boards, and the protruding space for conveyance overlaps and is fixed to a space for conveyance of an adjacent flexible circuit board.
(2) The tape-style flexible circuit board according to the above described (1), wherein the end portions in the direction of conveyance of the above described flexible circuit boards overlap and are fixed with the entire width in the direction perpendicular to the above described direction of conveyance.
(3) The tape-style flexible circuit board according to the above described (2), wherein the above described end portions of the flexible circuit boards overlap the adjacent flexible circuit board with a length of no greater than 1 mm in the direction parallel to the above described direction of conveyance, excluding the above described spaces for conveyance.
(4) The tape-style flexible circuit board according to any of the above described (1) to (3), wherein the above described protruding spaces for conveyance overlap the adjacent flexible circuit boards with a length of 1.5 mm to 30 mm in the direction parallel to the above described direction of conveyance.
(5) The tape-style flexible circuit board according to any of the above described (1) to (4), wherein an adhesive layer is provided between the above described overlapped portions of flexible circuit boards.
(6) The tape-style flexible circuit board according to the above described (5), wherein a cover layer for a circuit pattern is formed on the above described flexible circuit boards, and the cover layer and the above described adhesive layer have the same composition.
(7) A manufacturing method for a tape-style flexible circuit board, comprising: a step of sticking a number of flexible circuit boards on reinforcing plates with removable organic layers; a step of connecting the number of flexible circuit boards to each other; and a step of removing the connected flexible circuit boards from the reinforcing plates.
(8) The manufacturing method for a tape-style flexible circuit board according to the above described (7), wherein flexible circuit boards where spaces for conveyance are provided in pairs of end portions facing each other are used, at least a portion of the spaces for conveyance protrudes in the direction parallel to the direction of conveyance of the flexible circuit boards, and the protruding portion overlaps a space for conveyance of an adjacent flexible circuit board, and thereby, the number of flexible circuit boards are connected to each other.
(9) The manufacturing method for a tape-style flexible circuit board according to the above described (8), wherein the above described protruding space for conveyance overlaps a space for conveyance of an adjacent flexible circuit board with a length of 1.5 mm to 30 mm in the direction parallel to the above described direction of conveyance.
(10) The manufacturing method for a tape-style flexible circuit board according to any of the above described (7) to (9), wherein the end portions in the direction of conveyance of the above described flexible circuit boards overlap the adjacent flexible circuit boards with the entire width in the direction perpendicular to the above described direction of conveyance.
(11) The manufacturing method for a tape-style flexible circuit board according to the above described (10), wherein the end portions in the direction of conveyance of the above described flexible circuit boards overlap the adjacent flexible circuit boards with a length of no greater than 1 mm in the direction parallel to the above described direction of conveyance, excluding the above described spaces for conveyance.
(12) The manufacturing method for a tape-style flexible circuit board according to any of the above described (7) to (11), wherein overlapped portions are bonded together with a resin so that the above described number of flexible circuit boards is connected to each other.
(13) The manufacturing method for a tape-style flexible circuit board according to the above described (12), wherein the above described number of flexible circuit boards is bonded together by heating the above described resin to a temperature of no lower than the glass transition point of the above described resin.
(14) The manufacturing method for a tape-style flexible circuit board according to any of the above described (7) to (13), wherein flexible circuit boards where a circuit pattern is formed on at least one surface are used.
(15) The manufacturing method for a tape-style flexible circuit board according to the above described (14), comprising a step of forming a cover layer on the above described circuit pattern, wherein an adhesive layer of a resin which has the same composition as the above described cover layer is formed in a portion with which adjacent flexible circuit boards overlap in the step of forming a cover layer.
(16) The manufacturing method for a tape-style flexible circuit board according to the above described (14) or (15), wherein an electronic part is connected to the above described circuit pattern, and after that, the connected flexible circuit boards are removed from the reinforcing plates.
(17) A manufacturing apparatus for a tape-style flexible circuit board, comprising: a connection means for connecting a first flexible circuit board to a second flexible circuit board which is laminated onto a reinforcing plate with a removable organic layer; and a winding means for winding the connected flexible circuit boards.
(18) The manufacturing apparatus for a tape-style flexible circuit board according to the above described (17), comprising: the conveyance means for conveying a number of the reinforcing plate onto which flexible circuit boards are laminated; and a removing means for removing the above described first flexible circuit board from the reinforcing plate.
(19) The manufacturing apparatus for a tape-style flexible circuit board according to the above described (17), wherein the above described connection means comprises: an overlapping means for making the above described first flexible circuit board overlap the above described second flexible circuit board laminated onto the reinforcing plate with a resin; and a heat and pressure application means for heating the overlapped flexible circuit boards to a temperature of no lower than the glass transition point of the resin and pressing the overlapped flexible circuit boards.
(20) The manufacturing apparatus for a tape-style flexible circuit board according to the above described (19), wherein the above described heat and pressure application means comprises a heat and press head having a length of no greater than 1 mm in the direction of conveyance of the flexible circuit boards, excluding the portion for heating and pressing a space for conveyance of a flexible circuit board.

### Effects of the Invention

According to the present invention, the loss in the connection portion can be reduced while keeping the strength of connection high when a number of sheet-style flexible circuit boards are connected to each other so as to form a tape-style flexible circuit board. In addition to the reduction of the loss of flexible circuit boards for the connection, the loss in time for recognizing and feeding the connection portion can be reduced when an electronic part is bonded to the tape-style flexible circuit board. In particular, according to the manufacturing method and the manufacturing apparatus of the present invention, a number of flexible circuit boards are connected to each other on reinforcing plates, and therefore, the flexible circuit boards are easy to handle, and in addition, a high precision of location can be secured so that two flexible circuit boards can be connected to each other without fail.

### BRIEF DESCRIPTION OF THE DRAWINGS

Fig. 1 is a schematic diagram showing the connection between flexible circuit boards according to one embodiment of the present invention;
Fig. 2 is a schematic diagram showing a wide sheet-style flexible circuit board including a number of strips of sheet-style flexible circuit boards;
Fig. 3 is a schematic diagram showing the connection between flexible circuit boards according to one embodiment of the present invention;
Fig. 4 is a schematic diagram showing the connection between flexible circuit boards according to one embodiment of the present invention;
Fig. 5 is a schematic diagram showing the connection between flexible circuit boards according to one embodiment of the present invention;
Fig. 6 is a diagram illustrating a peel angle when a flexible circuit board is peeled;
Fig. 7 is a schematic diagram showing a manufacturing apparatus according to one embodiment of the present invention;
Fig. 8 is an enlarged diagram showing a connection portion between flexible circuit boards in the apparatus of Fig. 7;
Fig. 9 is a schematic diagram showing a heating and pressing means in the apparatus of Fig. 7;
Fig. 10 is a schematic diagram showing a manufacturing apparatus according to one embodiment of the present invention;
Fig. 11 is a schematic diagram illustrating a pressing means and its operation in the apparatus of Fig. 10;
Fig. 12 is a schematic diagram showing a manufacturing apparatus according to one embodiment of the present invention;
Fig. 13 is a schematic diagram showing a manufacturing apparatus according to one embodiment of the present invention;
Fig. 14 is a schematic diagram illustrating the operation of the apparatus of Fig. 13;
Fig. 15 is a schematic diagram showing a laminating apparatus which is appropriately used in the apparatus according to the present invention;
Fig. 16 is a schematic diagram showing a wide sheet-style flexible circuit board including a number of strips of sheet-style flexible circuit boards;
Fig. 17 is a schematic diagram showing a temporary connection between flexible circuit boards according to one embodiment of the present invention;
Fig. 18 is a schematic diagram showing a state where sprocket holes are created in the flexible circuit boards of Fig. 17; and
Fig. 19 is a schematic diagram showing a state into which the flexible circuit boards of Fig. 18 are slit.

### Description of Reference Numerals

1a, 1b, 53, 101, 201a, 201b, 201c, 301a, 301b, 363, 400, 515: flexible circuit board
1d: tape-style flexible circuit board
2, 369: circuit pattern
3, 368: cover layer
4a, 4b: space for conveyance
5a, 5b, 15a, 15b, 20a, 20b, 21a, 21b, 25, 26, 115: protruding portion of flexible circuit board
6a, 6b, 16a, 16b, 17, 116, 367, 413: adhesive layer
7: length of spaces between circuit patterns
8, 365: holes for conveyance (sprocket holes)
9: width of protruding portion
10: length of protruding portion in direction of conveyance 13: sheet
50: peel angle
51, 103a, 103b, 103c, 203a, 203b, 203c, 303a, 303b, 303c, 504: reinforcing plate
52, 102a, 102b, 102c, 202a, 202b, 202c, 302a, 302b, 503: removable organic layer
54, 104a, 104b, 104c, 204a, 204b, 204c, 501: base table
55, 106, 206, 306: separating roll
105, 416: heat and press application means
107, 207, 307: roll
108, 208, 308, 407: winding roll
109, 209, 309, 402, 406: spacer
110, 210, 310, 405: spacer supplying roll
111: control apparatus
112, 212, 500: base
113, 213, 505: rail
117: heater block
118: head
119: axis
120, 220, 333: nipping means
205: pressing means
216, 316, 409: adhesive tape
238: separator
239: vacuum suction table
304: group of conveyance rolls
330: positioning jig
331: back-up roll
332: pressing roll
364: adhesive tape
401: unwinding roll
403: spacer winding roll
404: permanent connection unit
410a, 410b: mold
411, 412: suction stage
414, 415: suction arm
502: electrostatic charge apparatus
506: guide
507: nut
508: 509: bracket
510: ball screw
511: motor
512: flexible textile
513: support
514: frame
516: squeegee

### BEST MODE FOR CARRYING OUT THE INVENTION

In the tape-style flexible circuit board according to the present invention, a number of flexible circuit boards where a circuit pattern is formed on at least one surface are connected to each other.

In the present invention, flexible circuit boards mean base films on which a circuit pattern is formed, before a circuit pattern is formed or a circuit pattern is being formed. As for the base films, plastic films are used. Films, for example, of polycarbonate, polyether sulfide, polyethylene terephthalate, polyethylene naphthalate, polyphenylene sulfide, polyimide, polyamide, and liquid crystal polymers can be adopted. From among these, polyimide films are excellent in resistance to heat and resistance to chemicals, and therefore, appropriately adopted. In addition, liquid crystal polymers are also appropriately adopted because of their excellent electrical properties, such as low dielectric loss, and their low moisture absorption. It is also possible to adopt a flexible glass fiber reinforced resin sheet. In addition, any of these films may be layered on top of each other.

As for the resin of the above described glass fiber reinforced resin sheet, epoxy, polyphenylene sulfide, polyphenylene ether, maleimide (co)polymer resins, polyamide and polyimide can be cited as examples.

It is preferable for the thickness of the flexible circuit boards to be small for the reduction of weight, the miniaturization or the creation of microscopic via holes, and it is preferable for it to be no greater than 125 µm. Meanwhile, it is preferable for the thickness to be great enough to secure the physical strength and maintain flatness, and it is preferable for it to be no less than 4 µm.

It is preferable for the circuit pattern formed on a flexible circuit board to be formed mainly of copper having a small resistivity. In order to form a circuit pattern, a well-known technology, such as that using a subtractive method, a semi-additive method or a full-additive method, can be adopted. From among these, it is preferable to adopt a semi-additive method or a full-additive method for the formation of a microscopic pattern. Furthermore, solder plating, tin plating or gold plating can be appropriately carried out for solder joints, or a solder resist can be appropriately formed for the protection of a metal layer.

The flexible circuit boards according to the present invention have a strip form, and spaces for conveyance are provided in a pair of end portions facing each other. The spaces for conveyance are the portions which are used when the manufactured tape-style flexible circuit board is handled in reel-to-reel processing. Sprocket holes are provided in the spaces for conveyance, and the amount of feeding of the tape-style flexible circuit board is controlled using these sprocket holes. Usually, the width of the spaces for conveyance is 3 mm to 4 mm on one side, and sprocket holes in square form having a side of 1.42 mm or a side of 1.981 mm are provided at intervals of 4.75 mm.

At least a portion of the spaces for conveyance protrudes in the direction parallel to the direction of conveyance of the flexible circuit boards (hereinafter, referred to as "direction of conveyance"). The protruding spaces for conveyance overlap and are fixed to the spaces for conveyance of the adjacent flexible circuit boards, and thereby, a tape-style flexible circuit board is formed. In such a configuration, the strength of connections of the tape-style flexible circuit board where a number of sheet-style flexible circuit boards are connected to each other becomes high, and loss in the connection portions can be reduced. Furthermore, when an electronic part is bonded to the tape-style flexible circuit board, the loss in time for recognizing and feeding the connection portions as well as the loss in time for resin molding and electrical testing after an electronic part has been bonded can be reduced in addition to the reduction in loss of the flexible circuit boards due to the connection.

A portion of the spaces for conveyance must protrude in the direction of conveyance, and it is preferable for it to be wide in order to increase the strength of connection when being fixed, and it is further preferable for the protrusion to have the same width as the maximum width of the spaces for conveyance.

It is preferable for the protruding portion of the spaces for conveyance to be long in the direction of the conveyance in order to increase the strength of connection. In the case where it is too long, however, the portions of the flexible circuit boards which are cut off and wasted in order to form the protruding portion become long. Meanwhile, in the fabrication of a flexible circuit board, in many cases, the surrounding region having a width of approximately 30 mm around the sheet becomes a portion that cannot be used for a product due to handling, the supply of power and the like. Therefore, it is preferable to create a protruding portion using this region because the portion of the flexible circuit board which is to be wasted can be reduced due to the creation of the protruding portion. Accordingly, it is preferable for the spaces for conveyance to protrude by a length of 1.5 mm to 30 mm in the direction of conveyance, and for these protruding portions to overlap an adjacent flexible circuit board.

Here, it is preferable for the strength of connection between flexible circuit boards to be no less than 5 N in order for the tape-style flexible circuit board to be stably conveyed, and it is more preferable for it to be no less than 10 N. The strength of connection is measured at a temperature of 150°C in an atmosphere for measurement using a "Tensilon", made by ORIENTEC Co., LTD, to which a heating part is added.

In the present invention, it is also preferable for the end portions in the direction of conveyance of the flexible circuit boards to overlap and be fixed to the adjacent flexible circuit boards with the entire width in the direction perpendicular to the direction of conveyance. In the case where the end portions in the direction of conveyance are overlapped and fixed with the entire width in addition to the protruding portions as described above, a trouble with conveyance where a center portion of the overlapping portions of the tape-style flexible circuit board is lifted up and caught or rubbed by a part in the proximity when the tape-style flexible circuit board is conveyed in a step of mounting an electronic part or a step of inspection in the latter stage can be prevented from occurring.

In the case where the end portions in the direction of conveyance are made to overlap with the entire width, it is preferable for the length of these overlapped portions in the direction of conveyance to be no greater than the space between the circuit patterns, excluding the space for conveyance, in order to reduce the loss of the portion having the circuit pattern. The current standard length of repetition of the circuit pattern is 23.75 mm to 33.25 mm, wherein the space between circuit patterns is 0.5 mm to 4.75 mm. However, the space between circuit patterns tends to be smaller for the effective use of the flexible circuit boards, and recently, there have been some cases where the space between circuit patterns was approximately 1 mm. Accordingly, in the case where the end portions in the direction of conveyance are made to overlap with the entire width, it is more preferable for the length in the direction of conveyance, excluding the space for conveyance, to be no greater than 1 mm.

It is preferable for the spaces for conveyance and the end portions in the direction of conveyance of the flexible circuit boards which are overlapped as described above to be bonded together with an adhesive layer which is provided between the overlapped portions in order to prevent the occurrence of trouble at the time of conveyance. Here, it is not necessary for the adhesive layer to be uniformly provided between the overlapped portions, and it may be discontinuously applied so as to be applied in dots, stripes, grid or the like.

The adhesive layer must allow the spaces for conveyance and the end portions in the direction of conveyance of the flexible circuit boards which are overlapped to be bonded together, and must endure the heating steps, such as the step of curing the molding resin. A polyimide based, epoxy based, acryl based or urethane based adhesive, for example, can be adopted. In addition, a material which is referred to as solder resist ink and generally used for the protection of a flexible circuit board can also be used for the adhesive layer.

An example of the polyimide based resin is SN-9000 (made by Hitachi Chemical Co., Ltd.), examples of the epoxy based resin are NPR-5 and NPR-11 (made by Nippon Polytech Corp.) as well as CCR-232GF (made by Asahi Chemical Research Laboratory Co., Ltd.), and an example of the urethane based resin is "plainset" AE-70-M11.

It is preferable for the adhesive layer to have high resistance to heat. Therefore, it is preferable for the glass transition point (Tg) of the resin to be no lower than 100°C, and it is further desirable for it to be no lower than 150°C, taking into consideration that there is a step of heat treatment, such as a thermal curing process, of a semiconductor sealing material. As for such a resin, a polyimide based resin or an epoxy based resin is preferable. Polyimide based resins and epoxy based resins both have high durability, and polyimide based resins are also high in resistance to chemicals, which is more preferable.

The overlapped flexible circuit boards are bonded together with an adhesive layer which intervenes between the two flexible circuit boards as described above, and in addition, they may be physically fixed using eyelets, rivets, threads or the like within a range as long as the space between the circuit patterns. The fixture using an adhesive layer and a method for physical fixture may be combined. In addition, circuit boards may be directly fused and fixed each other without an adhesive layer, or an adhesive tape may be laminated over two flexible circuit boards which are overlapped in a range within a space between the circuit patterns, and thus, may be fixed.

In the present invention, it is also preferable for a cover layer for a circuit pattern formed on a flexible circuit board to be provided. Such a cover layer is not particularly limited as long as it is formed of a resin which can protect the circuit on a flexible circuit board. In general, a material which is referred to a photosensitive or thermosetting solder resist ink used for the protection of flexible circuit boards can be adopted. Concretely, polyimide based, epoxy based and urethane based resins can be cited. An example of the polyimide based resin is SN-9000 (made by Hitachi Chemical Co., Ltd.), examples of the epoxy based resin are NPR-5 and NPR-11 (made by Nippon Polytech Corp.) as well as CCR-232GF (made by Asahi Chemical Research Laboratory Co., Ltd.), and an example of the urethane based resin is "plainset" AE-70-M11.

It is more preferable for the cover layer for a circuit pattern and the adhesive layer which intervenes between flexible circuit boards to be resins having the same composition. The formation of a cover layer and an adhesive layer of a resin having the same composition means that the cover layer and the adhesive layer can be formed practically at the same time, and thus, the number of manufacturing steps can be reduced. Furthermore, the number of heat treatments can be reduced, and thereby, adhesiveness between a base film that forms the flexible circuit board and the circuit pattern can be prevented from decreasing.

Here, in the case where end portions in the direction of conveyance of flexible circuit boards are not overlapped with the entire width, there is a possibility that a slight gap may exist between the end portion in the direction of conveyance of the first flexible circuit board and the end portion in the direction of conveyance of the second flexible circuit board. In such a case, it is preferable for the gap between the two flexible circuit boards to be filled in with a resin which is added in dots or lines, or an adhesive tape having a narrow width. In this manner, two flexible circuit boards are connected to each other with a relatively large area, and thereby, the connection can be improved in terms of ease of peeling through twist.

In addition, according to the present invention, a circuit pattern may include a resistor element or a capacitor element. Furthermore, it is also possible to layer an insulating layer and a wiring layer on at least one surface of a flexible circuit board so that the circuit board is multilayered.

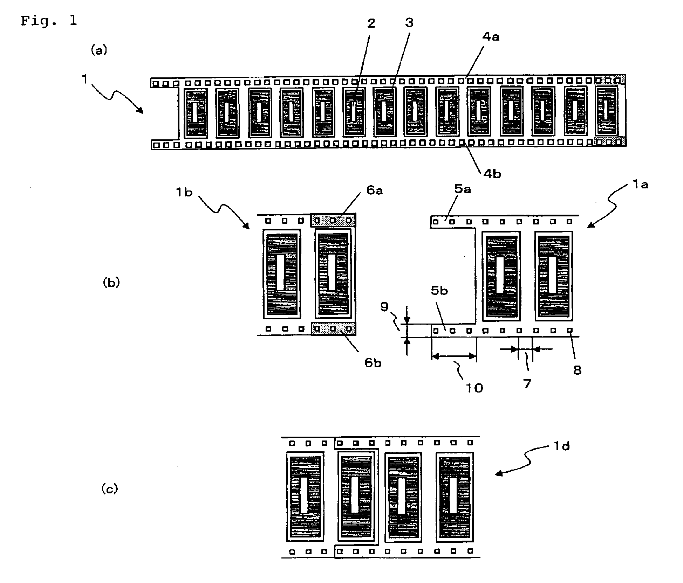

Figs. 1(a) to 1(c) show an example of a tape-style flexible circuit board according to a preferred embodiment of the present invention. Here, Fig. 1(a) is a schematic diagram showing a strip of a sheet-style flexible circuit board. Fig. 1(b) is an enlarged diagram showing end portions in the direction of conveyance of two flexible circuit boards before being connected. Fig. 1(c) is a diagram showing a state where the end portions in the direction of conveyance of the two flexible circuit boards shown in Fig. 1(b) overlap and are fixed.

As shown in Fig. 1(a), a circuit pattern 2 is formed on each flexible circuit board 1 in the tape-style flexible circuit board, and a cover layer 3 is formed so as to coat the circuit pattern 2. Spaces for conveyance 4a and 4b are provided in the pair of end portions facing each other of the flexible circuit board 1. As shown in Fig. 1(b), the spaces for conveyance 4a and 4b protrude (5a and 5b) in the direction of conveyance. As shown in Fig. 1(c), the protruding portions 5a and 5b of the spaces for conveyance 4a and 4b overlap the spaces for conveyance of another flexible circuit board 1b and are bonded with adhesive layers 6a and 6b so that a tape-style flexible circuit board 1d is formed. Here, symbol 7 indicates the length of the gaps between circuit patterns, and symbol 8 indicates holes for conveyance (sprocket holes).

It is preferable for the width 9 of the protruding portions 5a and 5b (that is to say, the length in the direction perpendicular to the direction of conveyance) to be great from the point of view of strength at the time of fixing, and thus, it is preferable for it to be the maximum width of the spaces for conveyance. The spaces for conveyance of COF's are generally 3 mm to 4 mm on one side. In addition, it is preferable for the length 10 of the protruding portions 5a and 5b in the direction of conveyance to be great in order to secure the strength at the time of fixing, and thus, it is preferable for it to be no less than 1.5 mm, and it is more preferable for it to be no less than 2 mm.

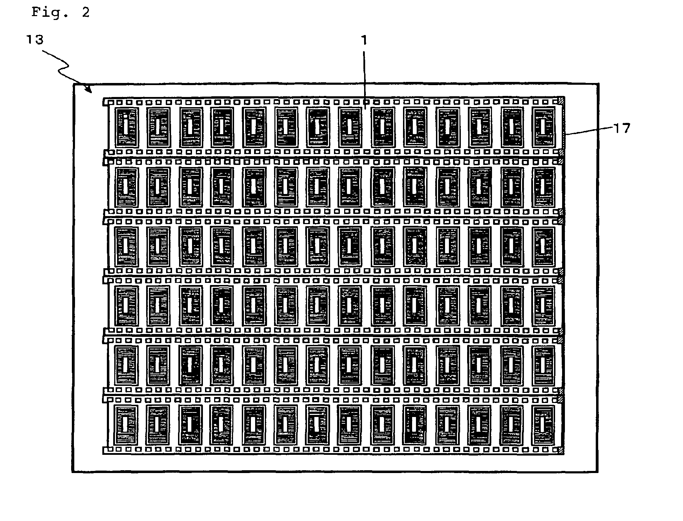

Here, as shown in Fig. 2, it is preferable for a number of flexible circuit boards 1 to be formed in one sheet 13, and in many cases, the surrounding portion of the sheet 13 with a width of approximately 30 mm becomes the portion that cannot be used as a product due to handling and the supply of power. Therefore, it is preferable to create protruding portions 5a and 5b using the portion that cannot be used as a product. The portion to be wasted in order to create protruding portions can be reduced. Accordingly, it is preferable for the upper limit of the length of protruding portions 5a and 5b in the direction of conveyance to be 30 mm, and it is more preferable for it to be 20 mm.

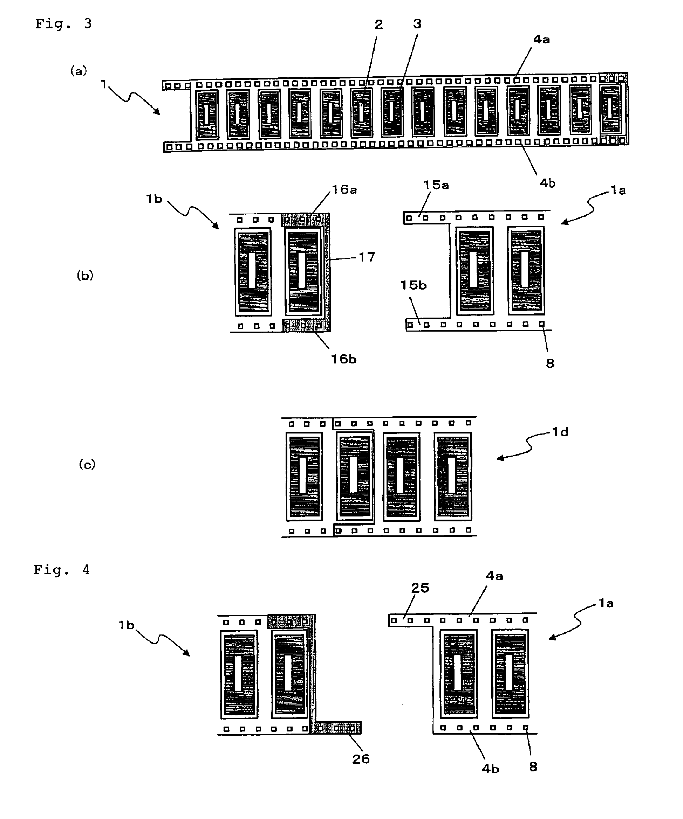

Figs. 3 (a) to 3 (c) show another example of the preferred embodiment. Here, Fig. 3(a) is a schematic diagram showing a strip of a sheet-style flexible circuit board. Fig. 3(b) is an enlarged diagram showing end portions in the direction of conveyance of two flexible circuit boards before being connected. Fig. 3(c) is a diagram showing a state where the end portions in the direction of conveyance of the two flexible circuit boards shown in Fig. 3(b) overlap and are fixed.

As shown in Fig. 3 (a), according to this embodiment, the basic configuration of each flexible circuit board is the same as that of the tape-style flexible circuit board shown in Figs. 1(a) to 1(c). In addition, as shown in Fig. 3(b), protruding portions 15a and 15b of one flexible circuit board overlap another flexible circuit board and are bonded together with adhesive layers 16a and 16b in the same manner as in the tape-style film circuit board shown in Figs. 1(a) to 1(c). However, in the tape-style flexible circuit board in Figs. 3 (a) to 3 (c), the end portions in the direction of conveyance of the two flexible circuit boards overlap and are bonded together with the entire width in the direction perpendicular to the direction of conveyance with an adhesive layer 17.

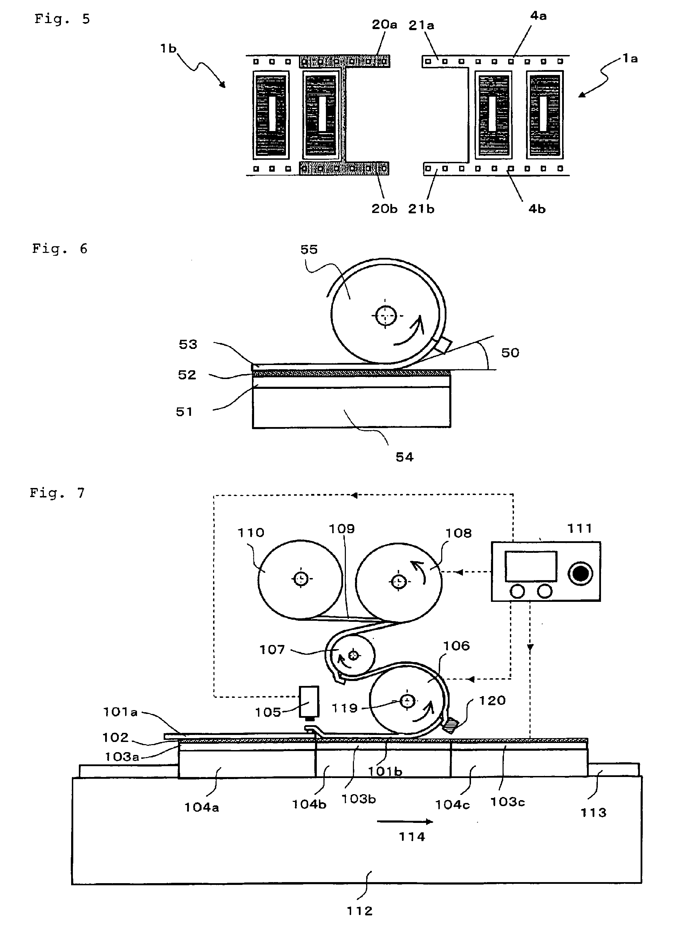

Figs. 4 and 5 show other preferred embodiments. In the tape-style flexible circuit board shown in Fig. 4, one of a pair of spaces for conveyance 4a and 4b of each flexible circuit board 1a and 1b protrudes in the direction of conveyance (protruding portion 25), and the other protrudes in the direction opposite to the direction of conveyance (protruding portion 26). The other points are the same as in the embodiment shown in Figs. 3(a) to 3(c). In the tape-style flexible circuit board shown in Fig. 5, each flexible circuit board 1a and 1b have spaces for conveyance 4a and 4b which protrude in the direction of conveyance (protruding portions 21a and 21b), and in addition, have protrusions in the direction opposite to the direction of conveyance (protruding portions 20a and 20b). Protruding portions 20a and 20b overlap and are fixed to protruding portions 21a and 21b, respectively.

In order to manufacture a tape-style flexible circuit board according to the present invention as described above, first, a flexible circuit board is manufactured in accordance with sheet processing. Sheet processing is different from reel-to-reel processing, which is general for TAB' s and COF' s and where processing required for flexible circuit boards is carried out while conveying a base film that has been fed out from a reel which is then wound up around another reel, and is processing where a base film in sheet form is conveyed and a process required for flexible circuit boards is carried out. After that, sheet-style flexible circuit boards are connected to each other in the below described manner, and a tape-style flexible circuit board is formed.
(a) A number of flexible circuit boards are placed on and stuck on reinforcing plates with removable organic layers; (b) the number of flexible circuit boards is connected to each other; (c) the connected flexible circuit boards are removed from the reinforcing plates, and thereby, a tape-style flexible circuit board is gained.

According to the method of the present invention as described above, a number of flexible circuit boards are connected to each other in a state where they are stuck on reinforcing plates with a removable organic layer, and therefore, the step of connection can be automated, and thus, making handling easy. In addition, automation becomes possible, and thereby, a high precision of location is also secured, and the two flexible circuit boards can be connected without fail.

Circuit patterns may be formed in advance on the flexible circuit boards or circuit patterns may be formed during the above described steps. It is preferable to form circuit patterns between the step (a) and the step (b) because a high precision of dimensions and low distortion can be gained.

Circuit patterns may be formed in accordance with a technology using a subtractive method, a semi-additive method, a full-additive method or the like. From among these, it is preferable to form circuit patterns in accordance with a semi-additive method because fine patterns can be formed.

In accordance with the full-additive method, the following process is carried out. A process for adding a catalyst, such as palladium, nickel or chromium, is carried out on the surface of a flexible circuit board on which a circuit pattern is to be formed, which is then dried. Here, the catalyst does not function as a core of plating growth as it is, but becomes the core of plating growth when an activating process is carried out. Next, a photoresist is applied with a spin coater, a blade coater, a roll coater, a bar coater, a die coater, a screen printer or the like, and is then dried. The photoresist is exposed to light through a photomask having a predetermined pattern and is developed so that a resist layer is formed on the portions which do not require a plating film. After this, a process for activating the catalyst is carried out, and a flexible circuit board is immersed in an electroless plating solution having a combination of copper sulfate and formaldehyde so that a copper plating film having a thickness of, for example, 2 µm to 20 µm is formed, and thus, a circuit pattern is gained.

In accordance with the semi-additive method, the following process is carried out. Chromium, nickel, copper or an alloy of these is sputtered onto the surface of a flexible circuit board on which a circuit pattern is to be formed, and a base layer having a thickness of, for example, 1 nm to 100 nm is formed. Next, a copper sputtering film having a thickness of, for example, 50 nm to 3000 nm is further formed on top of the base layer. This copper sputtered film has effects in which a sufficient conductance for the subsequent electrolytic plating is secured, adhesiveness of the metal layer is increased and pinhole defects can be prevented. A photoresist is applied on top of the base layer and the copper sputtered film that has been formed in this manner using a spin coater, a blade coater, a roll coater, a die coater, screen printing or the like, and is then dried. After that, the photoresist is exposed to light through a photomask having a predetermined pattern and is developed so that a resist layer is formed on the portions which do not require a plating film. Next, electrolytic plating is carried out using the base layer and the copper sputtered film as an electrode. As for the electrolytic plating solution, a copper sulfate plating solution, a copper cyanide plating solution, a copper pyrophosphate plating solution or the like is used. After the formation of a copper plating film, the photoresist is removed, and subsequently, the base layer is removed through slight etching, and thus, a circuit pattern is gained. Furthermore, plating of gold, nickel, tin or the like is carried out if necessary. Here, prior to the formation of the base layer, a plasma treatment, a reverse sputtering treatment, a primer layer application, an adhesive layer application or the like may be carried out on the surface of the flexible circuit board in order to increase adhesiveness. From among these, an adhesive layer application, such as an application of an epoxy resin based adhesive, an acrylic resin based adhesive, a polyamide resin based adhesive, a polyimide resin based adhesive or an NBR based adhesive, is preferable because of the large effects of improving adhesiveness.

In addition, in the case where the original flexible circuit boards are wide in the present invention, they are cut into slits having a desired width, for example, 35 mm, before or after the step (b) or after the step (c). As for the method for slitting the flexible circuit boards on a reinforcing plate into slits, a method using a laser, a high pressure water jet or the like is used. In addition, in the case where the flexible circuit boards are cut into slits after being removed from the reinforcing plate, methods for slitting with a blade or for punching out using a Thompson blade in addition to the methods using a laser or a high pressure water jet can also be adopted.

In the case where no sprocket holes are provided in the flexible circuit boards, holes are created before or after the step (b) or after the step (c) in the same manner. Holes may be created using a laser or a high pressure water jet on a reinforcing plate or may be created through punching after being removed from the reinforcing plate. Particularly, the number of sprocket holes is great, and the time for processing using a laser or a high pressure water jet becomes long, and therefore, it is preferable to create sprocket holes through punching after the flexible circuit boards are peeled from the reinforcing plate in order to increase the productivity.

According to the present invention, a tape-style flexible circuit board may be gained by connecting flexible circuit boards, which have been cut in advance into a form where at least a portion of a space for conveyance protrudes in the direction parallel to the direction of conveyance of the flexible circuit board, to each other in accordance with a method as described in the above (a) to (c), or a tape-style flexible circuit may be gained by temporarily connecting rectangular flexible circuit boards in accordance with a method as that described in the above (a) to (c) to each other and cutting thus gained tape-style flexible circuit boards into a form where at least a portion of a space for conveyance protrudes in the direction parallel to the direction of conveyance of the flexible circuit board while being permanently connected.

That is to say, (a') a number of rectangular flexible circuit boards are placed on and stuck on reinforcing plates with a removable organic layer; (b') the number of flexible circuit boards are temporarily connected to each other with an adhesive tape or the like; and (c') the connected flexible circuit boards are removed from the reinforcing plates so that a tape-style flexible circuit board is gained. (d') Next, this tape-style flexible circuit board is cut into a form where at least a portion of a space for conveyance protrudes in the direction parallel to the direction of conveyance of the flexible circuit board using a mold or the like, where the centers, which are cut out, are the portions for temporary connection. At this time, the front or the back portion of the flexible circuit boards which is cut and removed are held through vacuum suction or the like. (e') After that, one or both of the two divided flexible circuit boards are removed while being held by a vacuum suction or the like, and the spaces for conveyance protruding from one flexible circuit board are made to overlap and fix to the spaces for conveyance of the other flexible circuit board (permanent connection) so that a tape-style flexible circuit board is gained.

According to this method, flexible circuit boards are stuck on reinforcing plates for temporary connection, and therefore, the step of connection can be automated, and thus, making handling easy. In addition, automation becomes possible, and therefore, a high precision of location can be secured so that two flexible circuit boards can be temporarily connected without fail. The precision of permanent connection which follows the temporary connection receives the effects of the precision of the temporary connection, and therefore, the precision of permanent connection can be secured and the structure of the permanent connection apparatus can be simplified when temporary connection is carried out with high precision.

Circuit patterns may be formed on the flexible circuit boards in advance, or circuit patterns may be formed during the above described steps. It is preferable to form circuit patterns between the step (a') and the step (b') in order to achieve a high precision of dimensions with low distortion. In the case where the original flexible circuit boards are wide, it is preferable to carry out a slitting process between the step (c') and the step (d') or after the step (e') so that the slits have the width for the subsequent step. In the case where no sprocket holes are provided in the flexible circuit boards, it is preferable to carry out a punching process between the step (c') and the step (d') or after the step (e').

In the following, further detail for all of the above described methods is described.

In the case where an electrode for testing (does not remain as a part of the product) is placed at the outermost end of a circuit pattern, the portion of the flexible circuit board where the electrode for testing is provided can be used for connection in such a manner that the surface on the side opposite to the side where the electrode for testing is provided makes contact with another flexible circuit board when overlapping.

In order to connect a number of flexible circuit boards to each other, spaces for conveyance are provided in each pair of end portions facing each other of the flexible circuit boards. At least a portion of the spaces for conveyance protrudes in the direction of conveyance of the flexible circuit board, and the protruding spaces for conveyance overlap and are fixed to spaces for conveyance of an adjacent flexible circuit board. A number of flexible circuit boards are fixed in this manner, and thereby, the strength of connection in the tape-style flexible circuit board becomes high, and the loss in the connection portions can be reduced. Furthermore, the loss of the flexible circuit boards due to connection can be reduced, and in addition, the loss of time for recognizing and feeding connection portions can be reduced when an electronic part is bonded to the tape-style flexible circuit board.

It is preferable for the spaces for conveyance to protrude by a length of 1.5 mm to 30 mm in the direction of conveyance as described above so that the protruding portions overlap and are fixed to an adjacent flexible circuit board. Flexible circuit boards can be connected with a relatively large area of the end portion in the direction of the width, and thereby, peeling from the end portions in the direction of the width of the flexible circuit boards due to twist can be prevented. In addition, the portions of flexible circuit boards which are wasted when protruding portions are formed can be reduced.

Though the method for forming a protruding portion is not particularly limited, a method for punching out using a mold having a form with protruding portions and a method for cutting by scanning a laser, such as a YAG laser, along the desired form for protruding portions can be cited.

According to the present invention, it is also preferable for an end portion in the direction of conveyance of a flexible circuit board to overlap an adjacent flexible circuit board with the entire width in the direction perpendicular to the direction of conveyance as described above. In the case where flexible circuit boards overlap with the entire width, it is preferable for the length of overlapping in the direction of conveyance to be no greater than the gap between circuit patterns, excluding the space for conveyance. It is more preferable for the length to be no greater than 1 mm in the direction of conveyance.

Here, in the case where end portions in the direction of conveyance of flexible circuit boards do not overlap with the entire width, there is a possibility that a slight gap may be created between the end portion in the direction of conveyance of one flexible circuit board and the end portion in the direction of conveyance of the other flexible circuit board. In this case, it is preferable to add a resin in dots or in lines in order to fill in the gap. The resin may be added to the gap created between the two flexible circuit boards using a dispenser or a resin in sheet form may be placed in the gap created between the two flexible circuit boards. The resin may be added in the step of connecting the two flexible circuit boards or may be added in another step after the connection. In addition, an adhesive tape may be used.

As for the method for fixing a number of flexible circuit boards, it is preferable to form an adhesive layer of a resin as described above between the two overlapping flexible circuit boards, which are thus bonded together. In addition to the fixture using an adhesive layer, the circuit boards may be physically connected and fixed using eyelets, rivets, threads or the like within a range as long as the range is contained in the space between the circuit patterns. The fixture through adhesion using a resin and physical connection and fixture may be combined. In addition, circuit boards may be directly fixed each other. Concretely, the interface between overlapping circuit boards may be locally heated using a laser, and thereby, the circuit boards adhere to each other or the overlapping portion may be heated using a high-frequency welder so that the circuit boards adhere to each other. In addition, it is preferable to laminate an adhesive tape over the overlapping portion within a range in the space between circuit patterns so that circuit boards are fixed each other.

The method for forming an adhesive layer is not particularly limited as long as it is a method according to which two flexible circuit boards can be fixed each other. For example, a resin as described above may be applied to the overlapping portion of flexible circuit boards through a screen printing method or using a dispenser, and after that, may be dried and cured. In this case, a resin in liquid form or gel form may be used. In addition, an adhesive layer in sheet form, such as TSA-6705 (made by Toray Industries Inc.), may be used by processing, for example, punching, into a required form for use.

In order to bond flexible circuit boards to each other with an adhesive layer, the adhesive layer is heated so that the resin is once melted, and after that, the resin is cooled and hardened. It is desirable for the heating temperature to be a temperature higher than the glass transition point (Tg) of the used resin so that the resin is sufficiently melted and the adhesiveness is increased. The Tg of a general polyimide based solder resist is approximately 200°C to 250°C, and therefore, it is preferable for the heating temperature to be no lower than 250°C in the case where a polyimide based resin is used, and it is more preferable for the temperature to be no less than 300°C.

Here, when the adhesive layer is heated, it is preferable to locally heat the overlapping portion instead of heating the entirety of the overlapping flexible circuit boards. In the case where circuit patterns are plated with tin, for example, the thickness of the pure tin layer is adjusted to a predetermined range from the points of view of whisker preventing measures and conditions for metal bonding. When the circuit patterns undergo a further thermal history through the application of heat to the adhesive layer, however, there is a risk that the thickness of the pure tin layer may be out of the predetermined range.

It is better for the time for heating the adhesive layer to be short in order to increase the productivity. Therefore, it is effective to heat while applying pressure, whereas there is a risk that the flexible circuit boards may be distorted when too much pressure is applied, and therefore, it is preferable to apply pressure in a range from 0.1 N/mm² to 3 N/mm². In addition, the time required for connection can be shortened by suppressing the diffusion of heat using a stage of which the thermal conductivity is small.

In addition, two flexible circuit boards may overlap and be fixed each other while forming an adhesive layer instead of forming an adhesive layer in advance. In this case, a liquid adhesive is applied to an overlapping portion of one flexible circuit board using a dispenser or the like and dried, and then, another flexible circuit board to be connected may be mounted on top of this, and thus, the adhesive may be cured. In the case where a solventless adhesive is adopted, drying after application can be omitted.

Furthermore, when the adhesive layer is too thin, there is a risk that the strength of adhesion becomes small while when the adhesive layer is too thick, there is a risk that the adhesive may stick out from the joining portion at the time of joining, and therefore, it is preferable for the thickness after drying to be in a range from 0.5 µm to 20 µm, and it is more preferable for the thickness to be in a range from 1 µm to 10 µm.

According to the present invention, it is also preferable to form a cover layer for a circuit pattern formed on flexible circuit boards. As for the cover layer, resins as described above can be used.

As for the method for forming a cover layer, a resin as that described above may be applied using a spin coater, a blade coater, a roll coater, a bar coater, a die coater, a screen printer, a dispenser or the like, and may be dried and cured. In the case where a photosensitive solder resist is used, for example, the photosensitive solder resist is uniformly applied to a flexible circuit board on which a circuit pattern is formed using a spin coater, a blade coater, a roll coater, a bar coater, a die coater or the like, and then, dried, exposed to light, developed and cured so that a cover layer is formed. In the case where a thermosetting solder resist is used, the thermosetting resist is applied so as to match the form of a circuit pattern using a screen printer or a dispenser, and then, dried and cured so that a cover layer is formed.

It is preferable according to the present invention for a cover layer for a circuit pattern to be formed, and at the same time, for an adhesive layer which intervenes between flexible circuit boards to be formed, that is to say, it is preferable to form a cover layer and an adhesive layer practically at the same time. In general, the adhesiveness between the copper which forms a circuit pattern and a plastic film tends to be lower when heat treatment is repeated. The number of heat treatments can be reduced by forming a cover layer and an adhesive layer practically at the same time, and therefore, the adhesiveness between the flexible circuit board and the circuit pattern can be prevented from lowering. In addition, in the case where the circuit pattern is plated with tin, effects are gained where the adjustment of the thickness of the pure tin layer becomes easy.

As for the method for forming a cover layer and an adhesive layer practically at the same time, there is a method where a resin is simultaneously supplied to a portion for forming a cover layer and a portion for forming an adhesive layer on one flexible circuit board through screen printing or the like, and after that, dried and cured. In order to do this, it is necessary to design a mask so that a resin can be applied to the connection portions of a number of flexible circuit boards in addition to the portions of cover layers for circuit patterns. In addition, there is a method where a resin is sequentially supplied to a portion for forming a cover layer and a portion for forming an adhesive layer on one flexible circuit board using a dispenser or the like, and after that, dried and cured at the same time. Furthermore, there is a method where a resin in sheet form that has been formed in advance is laminated onto a portion for forming a cover layer and a portion for forming an adhesive layer, and then, cured. The methods for using a dispenser or a resin in sheet form are appropriate in the case where the thickness differs between the adhesive layer and the cover layer. Here, it is preferable for the cover layer and the adhesive layer to be provided in different application steps and undergo the subsequent drying and curing step at the same time because the number of heat treatment steps can be reduced.

In the tape-style flexible circuit board according to the present invention, a number of flexible circuit boards on reinforcing plates are connected to each other as described above.

When flexible circuit boards are placed on reinforcing plates, sheet-style base films which have been cut into a desired size in advance may be used in such a manner that these base films may be stuck on reinforcing plates as flexible circuit boards or a base film may be fed out from a roll for a long film while this is stuck on reinforcing plates as a flexible circuit board, and then, cut.

As for the reinforcing plate, plates having a small coefficient of linear expansion and a small coefficient of humid expansion, for example, plates of an inorganic glass, such as sodalime glass, borosilicate glass and quartz glass, ceramics, such as alumina, silicon nitride and zirconia, metals, such as stainless steel, invar alloys and titanium, and in addition, plates having a glass fiber reinforced resin, are preferable. From among these, plates of an inorganic glass and metal plates are preferable in that an appropriate flexibility can be gained. Furthermore, plates of which the main component is an inorganic glass are particularly preferable in that they are excellent in resistance to heat and resistance to chemicals, plates having a large area and a smooth surface are available at a low cost, plastic deformation hardly occurs, they hardly generate particles through contact with a conveyance apparatus, they are insulators on which nothing deposits through electroplating and the like.

In the case where a thin glass board is used as the reinforcing plate, torsion or warping becomes large due to the force of expansion or shrinkage of the flexible circuit board, and the glass board sometimes breaks when vacuum sucked onto the flat base table. In addition, it tends to become difficult to secure the precision of location due to a change in form of the flexible circuit board through vacuum suction and removal. Accordingly, it is preferable for the thickness of the glass board to be no less than 0.3 mm. Meanwhile, in the case where a thick glass board is used, it becomes difficult for the board to bend for removal, and in addition, flatness lowers due to unevenness in the thickness, and the precision of the exposure to light is also lowered. In addition, the load becomes large when being handled by a robot, and a quick operation cannot be achieved, making productivity low. Because of these points, it is preferable for the thickness of the glass board to be no greater than 1.1 mm.

In the case where a thin metal plate is used as the reinforcing plate, torsion or warping becomes great due to the force of expansion or shrinkage of the flexible circuit board, and thereby, the flexible circuit board changes in form due to the failure of vacuum suction onto the flat base table or due to the occurrence of torsion or warping of the metal substrate, and thus, a predetermined precision of location cannot be secured. In addition, when a circuit board is folded, it becomes a defect at this point in time. Accordingly, it is preferable for the thickness of the metal plate to be no less than 0.1 mm. Meanwhile, in the case of a thick metal plate, the flatness becomes low due to the unevenness in the thickness, and it becomes hard for the metal plate to bend for removal, making the precision of the exposure to light lower. In addition, the load becomes large when being handled by a robot, and a quick operation cannot be achieved, making productivity low. Because of these points, it is preferable for the thickness of the metal plate to be no greater than 0.7 mm.

When a flexible circuit board is placed on a reinforcing plate, a removable organic layer is made to intervene between the reinforcing plate and the flexible circuit board. It is necessary for this removable organic substance to have enough adhesiveness to prevent the flexible circuit board from moving during processing, and to be removed easily during removal without causing any distortion to the flexible circuit board. Accordingly, it is preferable for the substance to have adhesiveness in a range from weak adhesiveness to mid-level adhesiveness. Concretely, acryl based or urethane based adhesives, which are referred to as reusable adhesives, can be cited. Tacky silicon resins and tacky epoxy based resins can also be used.

In addition, substances of which the adhesiveness or tackiness reduces in a low temperature region, of which the adhesiveness or tackiness reduces when irradiated with ultraviolet rays, and of which the adhesiveness or tackiness reduces during heat treatment can also be used as an appropriate removable organic substance. From among these, substances of which the adhesiveness or tackiness reduces when irradiated with ultraviolet rays have a greater degree of change, and thus, preferable. As the substances of which the adhesiveness or tackiness reduces when irradiated with ultraviolet rays, two liquid cross linking type acryl based adhesives can be cited. In addition, as the substances of which the adhesiveness or tackiness reduces in a low temperature region, acryl based adhesives which change their form reversibly between a crystal state and an amorphous state can be cited.

It is preferable for the adhesiveness to the reinforcing plate of the removable organic layer to be greater than the adhesiveness to the flexible circuit board. As for the method for controlling the respective adhesiveness, there is a method for applying a removable organic substance to the reinforcing plate and making cross linking progress during a predetermined period of time in a state where air is blocked. According to this method, the adhesiveness on the surface on the side opposite to the reinforcing plate (on the flexible circuit board side) is lowered relative to the adhesiveness on the side facing the reinforcing plate so that the adhesiveness on both sides can be made different.

In the case where the above described removable organic layer is thin, the flatness becomes worse and the adhesiveness becomes uneven due to the unevenness in the film thickness, that is to say, the force required for peeling becomes uneven, and therefore, it is preferable for the thickness of the layer to be no less than 0.1 µm, and it is more preferable for the thickness to be no less than 0.3 µm. Meanwhile, in the case where the removable organic layer is thick, the effects of the organic layer being anchored to the flexible circuit board becomes greater, making the adhesiveness stronger. Accordingly, it is preferable for the thickness of the removable organic layer to be no greater than 20 µm, and it is more preferable for it to be no greater than 10 µm. Furthermore, in the case where an electronic part is bonded to a circuit pattern formed on the flexible circuit board on the reinforcing plate, the precision of location of this circuit pattern becomes important. Accordingly, it is particularly preferable for the thickness of the removable organic layer to be no greater than 5 µm in order to prevent the location of the circuit pattern from greatly changing in the direction of the thickness.

Here, the removable organic layer sometimes changes in form, making the surface uneven when an electronic part is bonded through the application of heat and pressure. When the organic layer is thick, the degree of change in form tends to be great, making the circuit pattern to which a part is bonded sink, and thus, a problem with the reliability of the wired circuit may arise. That is to say, when a circuit pattern sinks a great deal, the circuit pattern may make contact with an edge of the electronic part, and thus, may cause short circuiting. Accordingly, it is preferable for the amount of sinking to be no greater than 6 µm in order to secure the reliability of the wired circuit, and it is more preferable for it to be no greater than 3 µm. Here, the amount of sinking means the difference in the level created in the unevenness on the surface of the removable organic layer.

When the connected flexible circuit boards are removed from the reinforcing plates, it is preferable for the peel angle 50, which is the angle formed between the flexible circuit board 53 and the reinforcing plate 51 during peeling, to be in a range of no less than 1° and no greater than 80° as shown in Fig. 6. When the peel angle 50 is too great, folding or a change in form may occur in the circuit pattern made of a metal on the flexible circuit board 53 at the peel point. Meanwhile, when the peel angle 50 is too small, the force in the direction of stretching the flexible circuit board 53 becomes too great relative to the force used for peeling the flexible circuit board 53, and thereby, plastic deformation is caused in the circuit pattern and the flexible circuit board 53. Accordingly, the peel angle in order to peel the flexible circuit board 53 from the reinforcing plate 51 with low stress and without causing distortion is preferably in a range of no less than 1° and no greater than 80°, more preferably, in a range of no less than 2° and no greater than 70°, and most preferably, in a range no less than 5° and no greater than 60°.

It is appropriate to peel the flexible circuit board 53 along the separating roll 55 having a curvature in order to control the peel angle 50 in the above described manner. It is preferable for the radius of curvature of the separating roll 55 to be no less than 50 mm and no greater than 700 mm.

The flexible circuit boards that have been connected and peeled are rolled up around a reel using a winding means.

Here, such a peeling method can be adopted in the above described method for connection in one step, and can be adopted in the above described method for connection in two steps where temporary connection and permanent connection are separated.

In addition, according to the present invention, it is preferable to mount electronic parts, such as IC chips, resistors and condensers, onto a circuit pattern before a number of flexible circuit boards are connected to each other. When the flexible circuit boards are stuck on reinforcing plates, the connection of electronic parts to the circuit pattern with high precision becomes possible.

As for the method for connecting electronic parts to a circuit pattern, there is a method for bonding metals in the metal layer of tin, gold, solder or the like formed on the connection portions of a circuit pattern, and in the metal layer of gold, solder or the like formed on the connection portions of electronic parts through the application of heat and pressure, a method for applying an anisotropic conductive adhesive or a non-conductive adhesive to the space between the circuit pattern and the electronic parts, and curing this anisotropic conductive adhesive or non-conductive adhesive while applying pressure between the metal layer on the circuit pattern and the metal layer formed on the connection portions of the electronic parts so that the two are mechanically joined, and other similar methods.

Next, a manufacturing apparatus for a tape-style flexible circuit board according to the present invention is described.

The manufacturing apparatus according to the present invention is provided with a connection means for connecting one flexible circuit board to another flexible circuit board which is stuck on a reinforcing plate with a removable organic layer, and a winding means for winding up the connected flexible circuit board. It is preferable for the connection means to be provided with a conveyance means for conveying a reinforcing plate on which flexible circuit boards are stuck, and it is preferable for the winding means to be provided with a peeling means for peeling the connected flexible circuit board from the reinforcing plate.

Concretely, as shown in, for example, Fig. 7, the manufacturing apparatus is formed of a number of reinforcing plates 103a, 103b and 103c, a number of base tables 104a, 104b and 104c for holding and conveying these reinforcing plates, a heat and pressure application means 105 which is placed so as to face a reinforcing plate and is moveable in the upward and downward directions, a peeling roll 106 for controlling the peel angle when the connected flexible circuit board is peeled from the reinforcing plate 103, a winding roll 108 for winding up the peeled flexible circuit board, and the like.

The number of reinforcing plates 103a, 103b and 103c as well as the base tables 104a, 104b and 104c are respectively provided so as to be aligned in the direction of conveyance so that the end portions of the adjacent reinforcing plates and the base tables can be confronted each other.

A removable organic layer is provided to the reinforcing plates 103a, 103b and 103c, and flexible circuit boards 101a and 101b are placed on and stuck on these. At this time, the flexible circuit boards 101a and 101b are placed in such a manner that the protruding portions thereof protrude from the end portions of the reinforcing plates which are closest to the protruding portions (see flexible circuit board 101b). Here, the protruding portions may be formed in a state where flexible circuit boards 101 are placed on reinforcing plates 103 or the protruding portions may be formed before flexible circuit boards 101 are placed on reinforcing plates 103.

The base tables 104a, 104b and 104c move in the direction of arrow 114 in the figure along a rail 113 provided on a base 112 in sync with the rotation of the separating roll 106. In addition, suction holes are provided on the upper surface of the base tables 104a, 104b and 104c so that reinforcing plates 103a, 103b and 103c which are placed on the surface are sucked and held using a vacuum source not shown.

In the apparatus having this configuration, the reinforcing plate 103a on which the flexible circuit board 101a is stuck conveyed in the direction of arrow 114 in the figure along the rail 113, and an end portion thereof is confronted the reinforcing plate 103b which is conveyed before the reinforcing plate 103a. As a result, the protruding portion of the flexible circuit board 101b which is stuck on the reinforcing plate 103b overlaps the flexible circuit board 101a which is stuck on the reinforcing plate 103a.

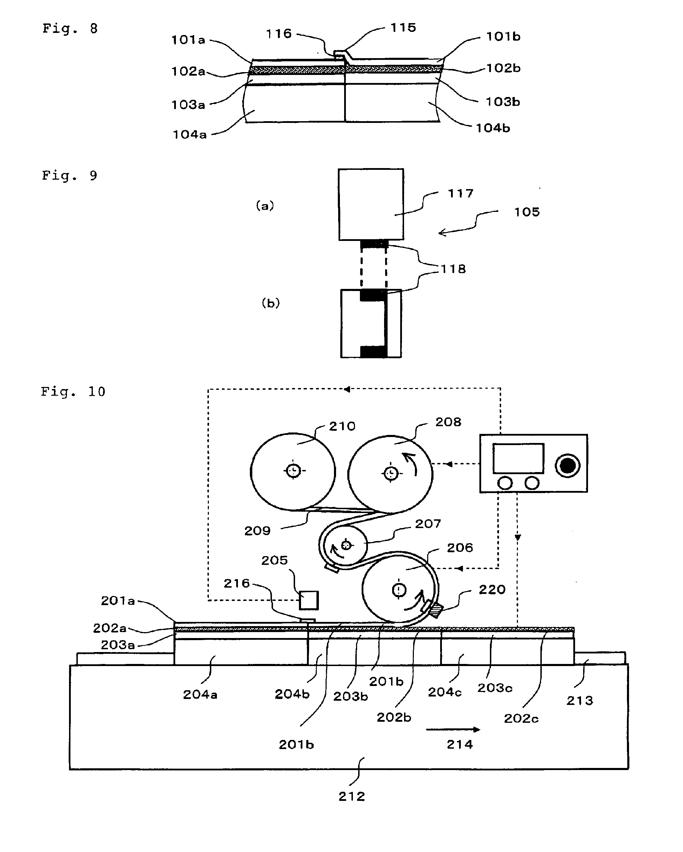

Fig. 8 is an enlarged diagram showing a portion through which one flexible circuit board is connected to another flexible circuit board on reinforcing plates. As shown in this figure, the protruding portion 115 of the flexible circuit board 101b which is conveyed overlaps the space for conveyance of the subsequent flexible circuit board 101a with an adhesive layer 116.

Here, when the end portions of the reinforcing plates are confronted each other, the protruding portion 115 is controlled to be held and lifted by a vacuum suction jig or the like (not shown) before the subsequent flexible circuit board 101a confronts the leading flexible circuit board 101b, and to make contact with the adhesive layer 116 after the subsequent flexible circuit board 101a is confronted to the leading flexible circuit board 101b.

Heat and pressure are subsequently applied to the overlapping portion by means of a heat and pressure application means 105. It is preferable to use a jig having a heat and pressure application surface of which the temperature can be raised and which is designed and processed so as to have a form which fits with the overlapping portion so that only the overlapping portion can be heated with the heat and pressure application means 105. This jig is pressed against the overlapping portion for heating and is subsequently removed, and thereby, heat and pressure can be applied locally. It is also possible to press the jig against the overlapping portion after heating the jig. In addition, it is also preferable for the heating to be assisted by a heater stage, infrared rays or the like.

As a concrete heat and pressure application means 105, the one shown in Figs. 9 (a) and 9 (b), for example, is preferable. Fig. 9(a) is a side diagram showing a heat and pressure application means 105, and Fig. 9(b) is a bottom diagram showing the same. The heat and pressure application means 105 shown in Figs. 9(a) and 9(b) is provided with a head 118, at an end of heater block 117, which fits with the form of the adhesive layer which is formed in the overlapping portion. The head 118 which is heated by the heater block 117 is lowered in the direction toward the overlapping portion by a raising and lowering means not shown so as to press the protruding portion 115 that is placed on the adhesive layer 116 from above. As the raising and lowering means, an air cylinder or a hydraulic cylinder can be adopted. The adhesive layer is locally heated by the heat and pressure application means 105 having this configuration, and thereby, two flexible circuit boards can be connected to each other.

The connected flexible circuit boards are removed from the reinforcing plates and wound up using a winding means. The winding means is formed of a separating roll 106 for controlling the peel angle, a winding roll 108 for the tape-style flexible circuit board, a roll 107 to assist in the running of the flexible circuit board and the like.

The separating roll 106 is connected to an encoder for measuring the angular speed of the rotation of the separating roll 106 not shown, an electromagnetic clutch for controlling the torque provided to the roll and a rotational motor via an axis 119. The rotational axis of the separating roll 106 has freedom only in the direction of rotation and is formed so that peeling progresses when the flexible circuit board 101 on the base table 104 is fed in the direction of arrow 114 in the figure. In this configuration, the winding means is simplified. Here, the separating roll 106 is rotated and the base table 104 is moved horizontally in a manner independent of each other, and the flexible circuit board 101 is controlled so as to be sequentially peeled from the reinforcing plate 103.

Suction holes may be provided on the surface of the separating roll 106 so that the portions of the flexible circuit board 101 which make contact with the separating roll can be sucked using a vacuum source (not shown).

Though the material of the surface of separating roll 106 is not particularly limited, elastic materials having cushioning properties, such as plastics, rubbers and plastic foams, are preferable. They prevent the flexible circuit board from being scratched. In addition, they absorb the height of an electronic part connected to the circuit pattern on the flexible circuit board or absorb the height of an adhesive tape used for the temporary connection of the flexible circuit boards due to an elastic change in form. As a result, the flexible circuit board and the circuit pattern can be prevented from being folded by an edge of an electronic part or an edge of the adhesive tape. In the case where the separating roll 106 has been processed so that a recess corresponding to an electronic part is created, effects are gained where it becomes difficult for the flexible circuit board to be folded by an edge of this recess.

In addition, it is also preferable for the material of the surface of the separating roll 106 to be a material having tackiness, such as a silicone resin. Such a material can prevent the amount of slippage between the separating roll 106 and the flexible circuit board from increasing due to the accumulated elongation of the flexible circuit board as peeling progresses. As a result, the peel angle can be prevented from increasing as peeling progresses. As for the standard of tackiness, it is preferable for the peeling strength in the direction of 180° to be no greater than 9.8 N/m when the flexible circuit board is peeled from the material on the surface of the reinforcing plate after they overlap.

When the surface of the separating roll 106 is too soft, it becomes hard for the peeling of the flexible circuit board to progress uniformly in the direction perpendicular to the direction in which peeling progresses. A problem easily arises in the case where an electronic part is mounted or in the case where sprocket holes are provided in the flexible circuit board. That is to say, the tension easily becomes uneven in the direction perpendicular to the direction in which peeling of the flexible circuit board progresses, and sometimes the flexible circuit board and the circuit pattern are distorted, decreasing the precision of location. Meanwhile, in the case where the surface of the separating roll 106 is too hard, the flexible circuit board is easily folded by an edge of a recess when a recess corresponding to an electronic part is created as described above, and sometimes the circuit pattern is damaged by the friction. Accordingly, an elastic material having a JIS-A hardness of 30° to 80° is preferable as the material of the surface of the separating roll 106.

In addition, it is preferable for the surface of the separating roll 106 which makes contact with the flexible circuit board 101 to have anti-static properties or conductive properties in order to prevent the electrostatic potential of the flexible circuit board 101 from increasing due to the charge from peeling. When the electrostatic potential increases, there is a risk that a charge will occur and that may damage the circuit pattern or an electronic part. An anti-static or a conductive member makes contact with the surface opposite to the surface of the flexible circuit board which is peeled from the reinforcing plate, and thereby, the potential can be lowered and the charge can be prevented even when the same charge occurs on the peeling surface. As for the anti-static material, plastics, rubbers, plastic foams and the like containing a conductive material and of which the surface resistance is no higher than 10¹² Ω are preferable.

The separating roll 106 is provided with a radius of curvature, taking into the consideration the amount of deformation and the peeling properties which are allowable for the flexible circuit board 101 on which a circuit pattern is formed, and partially different radii of curvature may be provided.

The connected flexible circuit board runs along the separating roll 106 and is peeled from the reinforcing plates 103 in a winding means having the above described configuration. At this time, tension is provided to the flexible circuit board by driving the winding roll 108.

It is preferable for the winding means to be provided with a nipping means 120 for temporarily sandwiching a connection portion of the flexible circuit board which is to be peeled together with the separating roll 106. It is preferable for the nipping means 120 to be formed in such a manner that it rotates around the axis 119 together with the separating roll 106 when sandwiching a connection portion of the flexible circuit board together with the separating roll 106, and it rotates freely around the axis 119, which is at the center, when it moves away from the separating roll 106 by means of an air cylinder (not shown).

As described above, it is preferable for the peel angle, which is an angle formed between the flexible circuit board during peeling and the reinforcing plate, to be no less than 1° and no greater than 80°, and this is controlled, for example, in the following manner.

When the radius of the separating roll 106 is R, this R is multiplied by the angular velocity of rotation which is observed by the encoder, and thereby, the circumferential velocity V1 on the surface of the separating roll 106 can be calculated. In the case where a flexible circuit board is sandwiched by the nipping means 120, the circumferential velocity V1 on the surface of the separating roll 106 is controlled so as to be greater than the horizontal moving velocity V2 of the base table 104, and V1 is controlled so as to be in a range which is not lower than V2 so that the torque that is applied to the separating roll 106 does not exceed a predetermined value by means of a torque limiting mechanism. As a result of this control, the peel angle can be prevented from increasing due to an expansion of the flexible circuit board, and thus, peeling can progress stably, and in addition, the flexible circuit board and the circuit pattern that is formed on top of this can be prevented from distortion.

The control of V1, V2 and the torque is possible in a mechanical system, an electrical system or a combination of the two. As for the mechanical torque controlling system, a system which is referred to as slip ring can be adopted, and this is preferable from the point of view of simplicity. As for the electronic torque controlling system, a system can be implemented by combining a torque sensor with a servo motor, and this is preferable in that the control is precise and the freedom of control is high. It is preferable for the initial setting values of V1 and V2 to satisfy that V1/V2 is no less than 1.01. As for the setting value for torque control, the value is set in a range which sufficiently prevents the peel angle from increasing as the peeling progresses, and prevents the circuit pattern made of a metal or the flexible circuit board from being plastically deformed, and an appropriate value is selected depending on the material, the width and the thickness of the flexible circuit board. It is preferable to provide a gap of 0.5 mm to 5 mm between the flexible circuit board 101 and the separating roll 106 in order to independently control V1 and V2.

Here, in the case where the nipping means 120 is not used, the tension by the winding roll 108 is controlled, and the rotational velocity of the separating roll 106 is controlled, and thereby, V1 and the torque are controlled.

V1, V2 and the torque are controlled by a control apparatus 111. In addition to the above, this control apparatus 111 controls the movement and the vacuum suction of the base table 104, the rotation of the separating roll 106, the rotation of the winding roll 108, the rising of the temperature of the heat and pressure application means 105, and the lifting and lowering of the heat and pressure application means 105.

The reinforcing plate 103c, from which the flexible circuit board has been peeled, is removed from the base table by means of a transfer means not shown. The base table 104c, from which the reinforcing plate 103c has been removed, is moved to the left side of the base table 104a by means of a moving means not shown, and a new flexible circuit board is mounted.

Here, in the case where there is no leading flexible circuit board, the initial flexible circuit board is connected to the lead film. Apparatuses for reels usually have a film path of several tens of cm to several m between the unwinding reel or the winding reel and the portion where a predetermined process is carried out. Accordingly, it is necessary to connect a lead film to the portion of the flexible circuit board that is processed in this apparatus where winding starts and to the portion where winding ends. Accordingly, it is preferable in the apparatus shown in Fig. 7 for one end of the lead film to be fixed to the winding roll 108 and to connect the end portion on the opposite side after passing through the roll 107 and the separating roll 106 to the end of the initial flexible circuit board where peeling starts before peeling starts. In the case where there is no subsequent flexible circuit board, a lead film having an appropriate length is connected to the final flexible circuit board before being wound around the winding roll.

In addition, as for the flexible circuit board, a flexible circuit board, from which a space for conveyance protrudes in the direction parallel to the direction of conveyance in advance, may be stuck on a reinforcing plates, and it is preferable in the configuration for the reinforcing plates beneath the protruding portion to be detached using a mechanical system or laser scribing so that the protruding portion can protrude from the reinforcing plate in the case where the protruding portion is formed through laser processing after the flexible circuit board is stuck on the reinforcing plate.

Next, an apparatus is described in the case where flexible circuit boards are temporarily connected, and after that, cut into a predetermined form, and then, permanently connected.

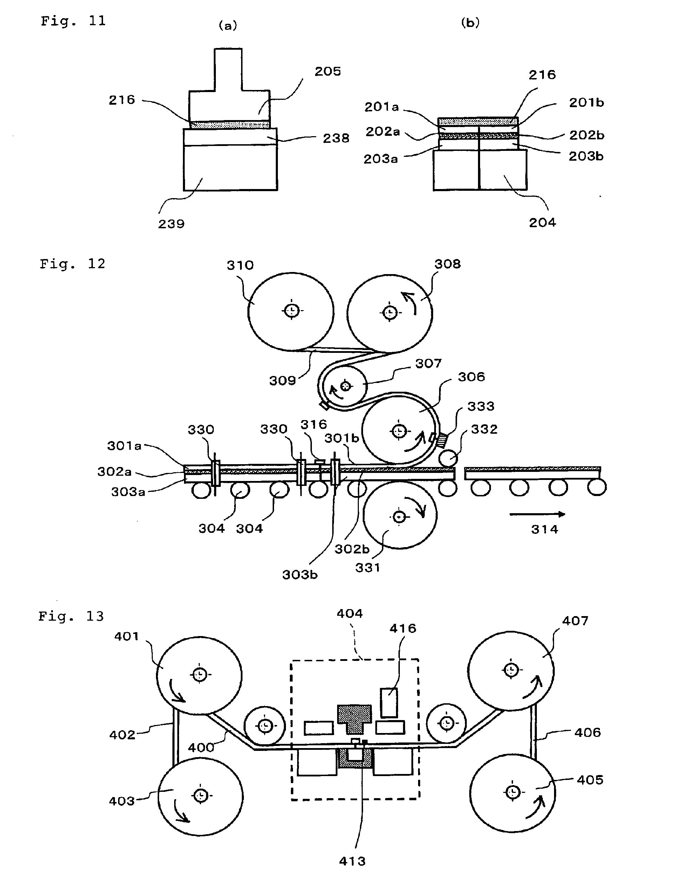

Fig. 10 shows a temporarily connecting apparatus. This apparatus is formed of a number of reinforcing plates 203a, 203b and 203c, a number of base tables 204a, 204b and 204c for holding and conveying these reinforcing plates 203a to 203c, a pressing means 205 which is placed so as to face a reinforcing plate 203 and is moveable in the upward and downward directions, a roll 206 for controlling the peel angle when the connected flexible circuit board is peeled from the reinforcing plate 203, and a winding roll 208 for winding the peeled flexible circuit board.

The number of reinforcing plates 203a, 203b and 203c as well as the base tables 204a, 204b and 204c are respectively provided so as to be aligned in the direction of conveyance, and they are aligned in such a manner that the end portions of the adjacent reinforcing plates and the base tables are confronted each other or have a relatively small predetermined gap in between.

Removable organic layers 202a, 202b and 202c are provided onto reinforcing plates 203a, 203b and 203c, and flexible circuit boards 201a and 201b are placed and stuck onto the tops of the moveable organic layers. At this time, it is preferable for the flexible circuit boards to be aligned in such a manner that the end portions thereof are aligned with the end portions of the reinforcing plates.

The base tables 204a, 204b and 204c move in the direction of arrow 214 in the figure along a rail 213 provided on the base 212 in sync with the rotation of the roll 206. In addition, suction holes are provided to the upper surfaces of the base tables 204a, 204b and 204c, and the reinforcing plates 203a, 203b and 203c which are placed on the surfaces are sucked and held using a vacuum source not shown.

The pressing means 205 is formed so as to hold an adhesive tape and be able to press the adhesive tape against flexible circuit boards so that the adhesive tape crosses over the adjacent flexible circuit boards.

In the temporarily connecting apparatus having this configuration, the reinforcing plate 203a onto which the flexible circuit board 201a is stuck is conveyed in the direction of arrow 214 in the figure along the rail 213 so that an end portion thereof is confronted the reinforcing plate 203b that is conveyed before the reinforcing plate 203a, or the reinforcing plate 203a is aligned with the reinforcing plate 203b with a relatively small predetermined gap in between. As a result, the reinforcing plate 203a and the reinforcing plate 203b are aligned in such a manner that an end portion of one flexible circuit board 201 that is stuck on the reinforcing plate 203b is confronted an end portion of the flexible circuit board 201a that is stuck on the reinforcing plate 203a, or has a predetermined relatively small gap from an end portion of the flexible circuit board 201a that is stuck on the reinforcing plate 203a. In this state, the pressing means 205 holding an adhesive tape 216 comes lower and presses the adhesive tape 216 against the two adjacent flexible circuit boards so that the adhesive tape crosses over the flexible circuit boards. The flexible circuit board which is temporarily connected in this manner is peeled from the reinforcing plate in the same manner as the description for the apparatus of Fig. 7 and is wound up around the winding roll 208.

Here, the pressing means 205 for holding and pressing an adhesive tape against flexible circuit boards is described in detail in reference to Figs. 11 (a) and 11(b). Fig. 11 (a) shows a state where an adhesive tape 216 is temporarily fixed to a separator 238. Fig. 11 (b) shows a state where an adhesive tape 216 is taped over flexible circuit boards on reinforcing plates which are confronted each other.

An adhesive tape 216 is cut in advance into pieces so as to match the width of the flexible circuit boards and is temporarily fixed to a separator 238 where a silicone resin layer is provided on a polyester film. The separator 238 is sucked from the rear side and fixed to a vacuum suction table 239.

The pressing means 205 peels the adhesive tape 216 from the separator 238 and moves the adhesive tape to the position above of the flexible circuit boards 201 when the two circuit boards 201a and 201b are confronted each other or are aligned so as to have a relatively small predetermined gap in between as described above. Next, the pressing means 205 presses the adhesive tape 216 against the two flexible circuit boards 201a and 201b so that the adhesive tape crosses over the flexible circuit boards which are thus connected to each other. Here, in the figure, 202a and 202b indicate removable organic layers, 203a and 203b indicate reinforcing plates, and 204a and 204b indicate base tables.

Though in the present embodiment the adhesive tape is cut in advance and temporarily fixed to a separator, a method for feeding out an adhesive tape in a state of being wound around a reel and pressing the adhesive tape against flexible circuit boards, and then, cut the adhesive tape into the width of the flexible circuit boards can be adopted.

In addition, rolls or chucks which sandwich the end portions of the flexible circuit board in the direction of the width from the top and the bottom can be used as the means for holding and conveying the reinforcing plates instead of the base tables. Fig. 12 shows an example using rolls.

In this apparatus, reinforcing plates 303a and 303b are placed on top of a group of conveyor rolls 304, and flexible circuit boards 301a and 301b are stuck on the reinforcing plates with removable organic layers 302a and 302b. The locations of the reinforcing plates 303a and 303b in the direction of the width of the conveyor rolls are adjusted by a positioning jig 330, and the reinforcing plate 303a is confronted against the rear end of the leading reinforcing plate 303b on which the flexible circuit board 301b is laminated or is aligned with the reinforcing plate 303b with a relatively small predetermined gap in between. A number of flexible circuit boards 301 can be sequentially aligned using the group of conveyor rolls 304 and the positioning jig 330.

At this time, it is preferable for the flexible circuit boards 301 to have the same length as the reinforcing plates 303 in the direction of conveyance. As a result of this, when the rear end of the leading reinforcing plate 303b and the front end of the subsequent reinforcing plate 303a are confronted each other, the rear end of the flexible circuit board 301b and the front end of the flexible circuit board 301a are confronted each other.

The portions which are confronted each other are fixed with, for example, an adhesive tape 316, and thus, the two flexible circuit boards are connected to each other.

The connected flexible circuit board is conveyed in the direction of arrow 314 in the figure and is peeled from the reinforcing plate 303b while being sandwiched amongst the separating roll 306, the group of conveyor rolls 304, the back-up roll 331 and the pressing roll 332. Though tension can be provided while the flexible circuit board is sandwiched between the separating roll 306 and the nipping means 333 so as to be holed, tension may be provided to the flexible circuit board by a winding roll 308. Here, in the figure, 309 indicates a spacer and 310 indicates a spacer supplying roll for supplying a spacer.

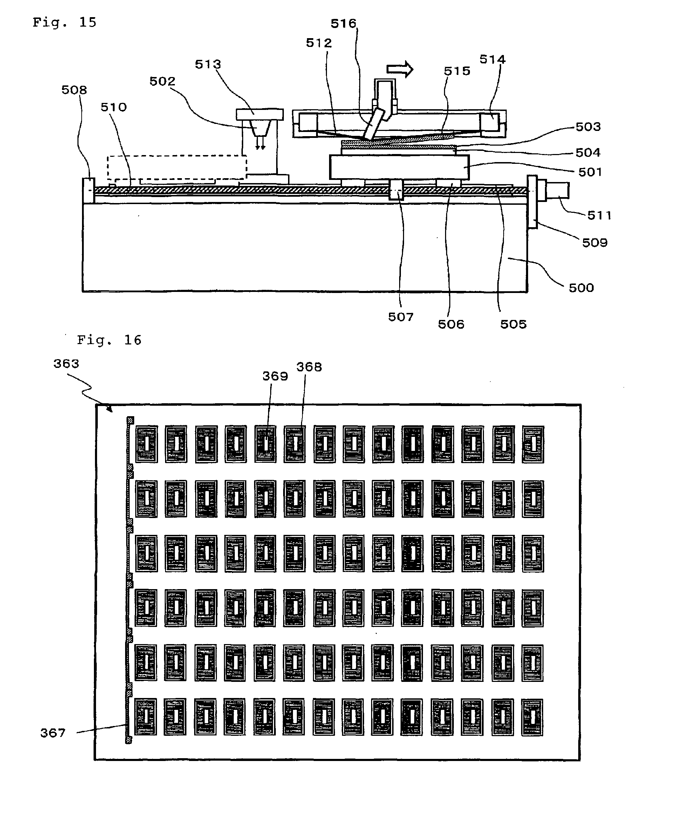

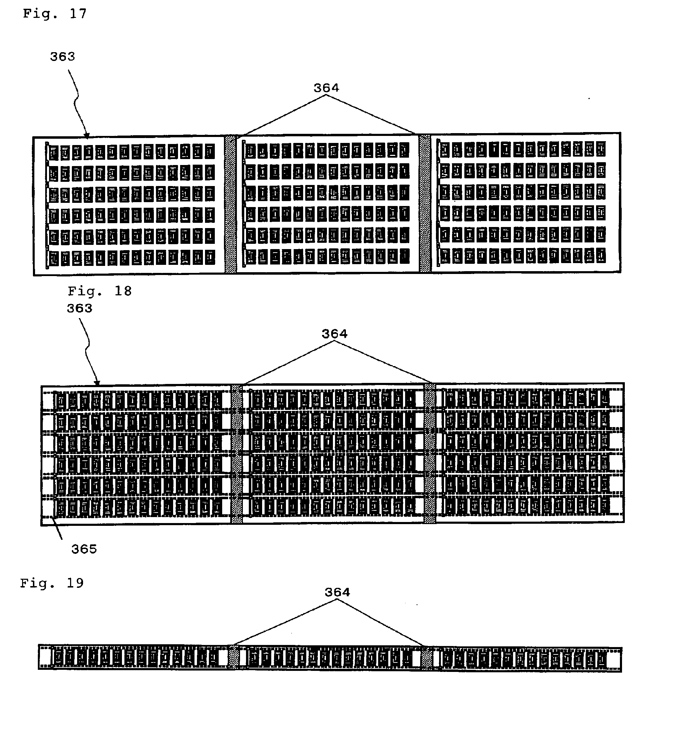

An adhesive layer for permanent connection may be formed in advance on the flexible circuit boards which are temporarily connected using an apparatus as described above. In addition, an adhesive layer for permanent connection may be formed after the temporary connection. A cover layer for a circuit pattern may be formed after the temporary connection. Fig. 16 shows a state where an adhesive layer is provided to a flexible circuit board 363 before being temporarily connected. An adhesive layer 367 is provided on the basis of the arranged circuit pattern. Fig. 17 shows a portion of a wide flexible circuit board 363 which is temporarily connected with adhesive tapes 364.

After that, the flexible circuit boards are cut as the predetermined form using, for example, the apparatus shown in Fig. 13, and the flexible circuit boards are permanently connected. Before the flexible circuit boards are permanently connected, sprocket holes may be provided to the flexible circuit boards, or the flexible circuit boards may be cut into slits having a predetermined width on the basis of the arrangement of the circuit patterns. Fig. 18 shows a state where sprocket holes 365 are created in a wide flexible circuit board 363 which is temporarily connected. Fig. 19 shows a slit having a predetermined width which is gained by slitting the flexible circuit board 363 of Fig. 18 and used in the subsequent step. Here, as described above, the permanent connection may be carried out on the wide flexible circuit board which are temporarily connected, or may be carried out on slits having a predetermined width which are used in the subsequent step.

The apparatus shown in Fig. 13 is provided with a unwinding roll 401 and a winding roll 407 for a temporarily connected flexible circuit boards 400, a spacer winding roll 403 for winding a spacer which is fed out simultaneously with the flexible circuit board 400, a spacer supplying roll 405 for supplying a spacer 406 between the wound flexible circuit boards 400, and a permanent connection unit 404.

The temporarily connected flexible circuit boards are supplied from the unwinding roll 401 to the permanent connection unit 404 in this apparatus. The spacer 402 which is wound together with a tape-style flexible circuit board is wound up around the spacer winding roll 403. The flexible circuit boards 400 that are conveyed to the permanent connection unit 404 are cut as a predetermined form, and after that, the flexible circuit boards are connected to each other, which are then wound up around the winding roll 407 together with the spacer 406 which is supplied from the spacer supplying roll 405. Here, an adhesive layer 413 for permanent connection is formed on the flexible circuit boards 400.

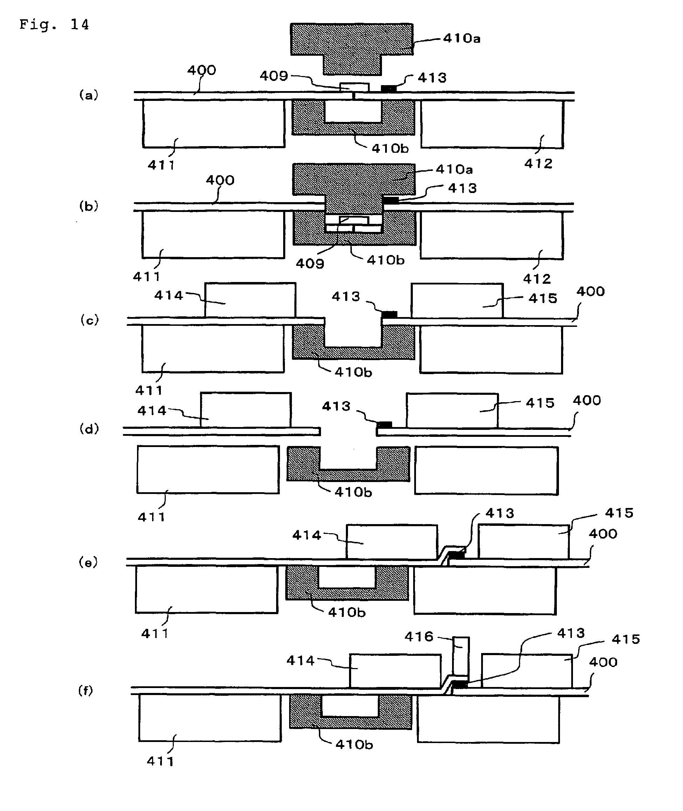

As shown in Figs. 14 (a) to 14 (f), the permanent connection unit 404 is provided with molds 410a and 410b as well as suction stages 411 and 412. The molds 410a and 410b are in a form such that at least the space for conveyance of a flexible circuit board that has been cut by these molds is in a form protruding in the direction parallel to the direction of conveyance.

The temporarily connected flexible circuit boards 400 are fed into this permanent connection unit 404 so that the adhesive tape 409 is placed at the location which is punched out by the molds 410a and 410b, and then, is sucked by the suction stages 411 and 412 (Fig. 14(a)).

In this state, the flexible circuit boards are punched out into a predetermined form by the molds 410a and 410b (Fig. 14(b)). After that, the mold 410a is withdrawn, and the portions of the flexible circuit boards which are the front and the back of the punched out portion are held by suction arms 414 and 415 (Fig. 14(c)). The suction by the suction stages 411 and 412 is relieved, and then, the flexible circuit boards are lifted up by the suction arms 414 and 415 (Fig. 14 (d)). The two flexible circuit boards are respectively moved to the downstream side and are placed so that the front end of the flexible circuit board on the downstream side overlaps the adhesive layer 413 provided on the rear end of the flexible circuit board on the upstream side (Fig. 14 (e)). In this state, a heat and pressure application means 416 is moved so as to be pressed against the flexible circuit board from the top at the location where the adhesive layer 413 is provided (Fig. 14 (f)). In this manner, the two flexible circuit boards which are separated by cutting and removing the adhesive tape 409 are connected to each other.

According to the present invention, flexible circuit boards are placed on reinforcing plates, and therefore, it is preferable to use a laminating apparatus as shown in, for example, Fig. 15.

The laminating apparatus shown in Fig. 15 is comprised with a base table 501 provided on top of a base 500, a flexible circuit board holding means which is placed so as to face the base table, an electrostatic charging apparatus 502, and so on.

The base table 501 holds a reinforcing plate 504 to which a removable organic layer 503 has been applied by vacuum suction and is formed of a rail 505, a guide 506, a nut 507, brackets 508 and 509, a ball screw 510 and a motor 511 so as to be moveable in the horizontal direction.

The flexible circuit board holding means is formed of a flexible textile 512 which is held by a frame 514 and a squeegee 516 for pressing this flexible textile 512 downward.

The electrostatic charging apparatus 502 charges the flexible textile 512. The electrostatic charging apparatus 502 is supported by a support 513 provided on the base 500 and is formed so as to be moveable upward and downward relative to the base table 501. The support 513 is removable so that the frame 514 and the base table 501, which move to the left and the right in Fig. 15, and the electrostatic charging apparatus 502 do not interfere with each other.

In the apparatus having this configuration, first, the base table 501 is moved to and left at a location on the left shown by the broken lines in Fig. 15, and a flexible circuit board 515 is mounted on top of the base table 501 using a conveying apparatus (not shown), sucked and fixed. Next, the base table 501 is moved at a constant velocity in the direction to the right so that the flexible circuit board 515 passes underneath the electrostatic charging apparatus 502. At this time, ionic air which is positively charged is blown downward from the electrostatic charging apparatus 502, and thereby, the flexible circuit board 515 is positively charged. The base table 501 is stopped when the base table 501 comes directly beneath the flexible textile 512 which is held by the frame 514, and the suction on the flexible circuit board 515 is relieved.

Next, the flexible textile 512 is lowered so as to be in the proximity of the flexible circuit board 515 on the base table 501 and is stopped where there is a predetermined gap between the flexible textile and the flexible circuit board. Though it is preferable for the gap between the flexible circuit board 515 and the flexible textile 512 to be no greater than 10 mm, it is also possible for the flexible circuit board 515 and the flexible textile 512 to make surface contact. After that, the squeegee 516 is pressed against the upper side of the flexible textile 512 so that a state is gained where the flexible circuit board 515 is sandwiched between the flexible textile 512 and the upper surface of the base table 501. At the same time, the squeegee 516 is moved from the location on the left side of the flexible circuit board 515 to the location on the right side, and thereby, the flexible textile 512 is made to make contact with the flexible circuit board 515, and the flexible circuit board 515 on the base table 501 is transferred onto the flexible textile 512 by means of electrostatic force.

After the flexible textile 512 holds the flexible circuit board 515, the squeegee 516 is taken away from the flexible textile 512, and the flexible textile 512 is moved upward for a while in order to stand-by. The squeegee 516 is moved to the location at the left end.

Next, the base table 501 is again moved to the left end and left there, and the reinforcing plate 504 on which a removable organic layer 503 has been formed in advance is mounted on the base table 501 using a conveying apparatus (not shown), sucked and held. Being sucked and held, the base table 501 is moved in the direction to the right and is stopped when it comes directly beneath the flexible circuit board 515 which is held by the flexible textile 512. The location at which the base table 501 is stopped at this time is determined in such a manner that the flexible circuit board 515 can be laminated on the reinforcing plate 504 in a predetermined location.

After that, the flexible textile 512 is made to be in the proximity of the reinforcing plate 504 on the base table 501 and is stopped so that there is a predetermined gap between the flexible circuit board 515 and the reinforcing plate 504. It is preferable for the gap between the flexible circuit board 515 and the reinforcing plate 504 to be no greater than 10 mm. Subsequently, the squeegee 516 is pressed against the flexible textile 512 from the top, and the flexible circuit board 515 which is held by the flexible textile 512 is pressed against the reinforcing plate 504 on the base table 501. At the same time, the squeegee 516 is moved from the location at the left end of the flexible circuit board 515 to the location at the right end so that the flexible circuit board 515 which is held by the flexible textile 512 is transferred onto the reinforcing plate 504 on the base table 501. As a result of this operation, the flexible circuit board 515 is laminated on the reinforcing plate 504 and is firmly held by the adhesiveness of the removable organic layer 503.

When the squeegee 516 moves to the right end and is stopped, the squeegee 615 is taken away from the flexible textile 512. Subsequently, the flexible textile 512 is raised and the suction power on the base table 501 is relieved, and after that, the reinforcing plate 504 on which the flexible circuit board 515 is laminated and which is placed on the base table 501 is carried out to the next step using a conveying apparatus (not shown).

In the following, the same operation is repeated so that the next flexible circuit board is laminated on the next reinforcing plate.

According to the present invention, a flexible circuit board can be laminated onto a reinforcing plate with low stress and low distortion by using such a laminating apparatus.

In addition, according to the present invention, a removable organic layer is provided between the reinforcing plate and the flexible circuit board as described above. Therefore, it is preferable for the manufacturing apparatus to be provided with an organic material applying means and an organic material drying means for drying the applied organic material, not shown.

As the organic material applying means, a spin coater, a blade coater, a roll coater, a bar coater, a die coater, a screen printer and the like can be used. From among these, it is preferable to use a die coater in order to uniformly apply such an organic material to a sheet-style reinforcing plate which is fed intermittently. Here, the organic material applying means may apply a removable organic material to a flexible circuit board. In addition, a removable organic material may once be applied to a separator which is independently prepared, and then, may be transferred to a reinforcing plate after being dried.

As the organic drying means, a heating dryer, a vacuum dryer, a hot plate and the like can be used. In addition, it is preferable to provide a period of time during which a separator (film where a silicone resin layer is provided on a polyester film) is left on the removable organic layer which is coating a reinforcing plate. The adhesiveness of the removable organic material gradually lowers during this period of time during which the separator is left as a result of the progression of cross linking, and the lowering of the adhesiveness of the surface on the separator side is greater, and therefore, the removable organic layer stays on the reinforcing plate when the flexible circuit board is removed from the reinforcing plate, and the step of cleaning the flexible circuit board after peeling can be omitted. Instead of laminating a separator, the reinforcing plate with a removable organic layer can be stored in a nitrogen atmosphere or in a vacuum. The period for drying and the temperature for drying can be selected so that a desired adhesiveness can be gained.

According to the present invention, it is preferable to add a means for forming an adhesive layer on a flexible circuit board. The adhesive layer forming means is comprised with an adhesive layer applying means and a drying means. As the adhesive layer applying means, a screen printer or a dispenser can be used in order to form a pattern. Here, in the case where a cover.layer and an adhesive layer for fixing an overlapping portion are formed simultaneously as described above, it is preferable to use a screen printer. As the drying means, a hot air oven and a hot plate can be used.

### Examples

In the following, the present invention is described in further detail by citing examples, but the present invention is not limited to these.

### Example 1

A tape-style polyimide film ("Kapton"150EN (trade name), made by Dupont-Toray Co. , Ltd.) having a thickness of 25 µm was prepared as a base film which formed a flexible circuit board. An alloy layer of chromium and nickel, of which the weight ratio was chromium : nickel = 5 : 95 and a thickness of 15 nm, and a copper layer having a thickness of 150 nm were layered on the polyimide film in this order using a sputtering apparatus for reel-to-reel processing on a tape-style circuit board.

A removable organic material was applied to sodalime glasses (300 mm × 350 mm having a thickness of 1.1 mm) which are reinforcing plates using a die coater, and was dried at 80°C for two minutes. As the removable organic material, a mixture of a ultraviolet ray curing type adhesive "SK Dyne" SW-22 (made by Soken Chemical and Engineering Co. , Ltd.) and an curing agent L45 (made by Soken Chemical and Engineering Co., Ltd.) at a weight ratio of 100: 3 was used. The thickness of the removable organic layer was 2 µm after being dried. Next, a film for blocking air (film where a silicone resin layer that can be easily removed is provided on a polyester film) was laminated onto the organic layer, which was then left for one week.

The above described polyimide film on which a metal layer was provided was cut into 300 mm × 350 mm. The above described film for blocking air that was laminated on the glass was peeled off, and then, the polyimide film on which a metal layer was deposited was laminated onto the removable organic layer using a laminating apparatus shown in Fig. 15. A flexible textile 512 made of a polyester mesh was charged by an electrostatic charging apparatus 502, and the polyimide film on which a metal layer was deposited (flexible circuit board 515) was sucked to the flexible textile. Next, a glass on which a removable organic layer 503 was applied (reinforcing plate 504) was held on a base table 501 through vacuum suction. The polyimide film (flexible circuit board 515) was pressed against the removable organic layer 503 together with the flexible textile 512 using a squeegee 516 so that the polyimide film (flexible circuit board 515) was transferred onto the glass (reinforcing plate 504) side. After that, the glass side was irradiated with ultraviolet rays of 1000 mJ/cm², and the removable organic layer was cured. A positive-type photoresist was applied to the top of the metal layer using a spin coater and was dried at 80°C for 10 minutes. The photoresist was exposed to light through a photomask and was developed so that a photoresist layer having a thickness of 12 µm was formed in portions where a plating layer was unnecessary.

A pattern which was formed on one polyimide film as described above was as follows. First, a circuit pattern having a length of 42 mm in the direction of the length of 300 mm of the glass and a length of 23 mm in the direction of the length of 350 mm of the glass was prepared, and this was referred to as one unit. Units like this were arranged next to each other in six columns at a pitch of 48 mm so as to be symmetrical relative to the center of the glass in the direction of the length of 300 mm. 14 units were arranged at a pitch of 23.75 mm so as to be symmetrical relative to the center of the glass in the direction of the length of 350 mm. The distance between units in the direction of the length of 350 mm of the glass was 0.75 mm.

As a result, six strips of sheet-style flexible circuit boards having the size of the final product were formed in one polyimide film. Here, at this stage, the polyimide film was not yet cut into strips.

Wires (inner leads) for the connection to an IC with bumps having a pitch of 25 µm were placed on a circuit pattern. That is to say, wires having a pitch of 25 µm and a width of 10 µm were placed in a rectangle having a length of 19.975 mm in the direction of the length of 42 mm of the circuit pattern and a length of 1.975 mm in the direction perpendicular to the above.

Next, a copper layer having a thickness of 8 µm was formed through electrolytic plating in a copper sulfate plating solution using the above described metal layer as an electrode. The photoresist was removed with a photoresist removing solution, and subsequently, the copper layer and the chromium-nickel alloy layer beneath the resist layer were removed through soft etching using a hydrogen peroxide-sulfuric acid based solution. Subsequently, a tin layer having a thickness of 0.4 µm was formed on the copper plating layer through electroless plating, and thus, a circuit pattern was gained.

After that, a cover layer for protecting a circuit pattern and an adhesive layer for connection were simultaneously formed using a screen printer. As shown in Fig. 16, a cover layer 368 was formed by applying a resin only onto the circuit pattern 369 and the periphery of this. An adhesive layer 367 was formed by applying a resin onto an area having a width of 2.8 mm and a length of 11.8 mm in the space for conveyance where the protruding portion of another flexible circuit board overlapped for the permanent connection and to an area having the entire width of the area between the space for conveyance in the direction which was perpendicular to the direction of conveyance and a length of 0.2 mm in the direction of conveyance. After that, the resin was cured in an oven at 120°C for 90 minutes, and thus, a cover layer 368 having a thickness of 10 µm and an adhesive layer 367 were gained.

Solder resist SN-9000 (made by Hitachi Chemical Co., Ltd.) was used for the cover layer and the adhesive layer. The glass transition point Tg of this resin was measured in accordance with a TMA (thermal mechanical analysis) method after curing at 120°C for 90 minutes and was found to be 212°C. Here, "Exstar 6000", made by Seiko Instruments Inc., was used as an apparatus, and a single layer of a solder resist after being thermally cured was prepared as a sample having a size of 10 mm × 10 mm. As for the conditions for measurement, the rate of increase of the temperature was 5°C/min, and as the measuring method, an extension method was used where the maximum value in the ratio of change was defined as Tg.

Subsequently, the polyimide films were temporarily connected in the apparatus shown in Fig. 10, peeled from the glass and wound up around a roll. Here, the polyimide films were arranged so that the side having a length of 350 mm of each polyimide film was oriented in the direction of conveyance before temporary connection. The radius of the separating roll 206 was 155 mm, and polyurethane rubber having a hardness of 70° was used as the surface of the separating roll. As the adhesive tape 216 for the temporary connection, an adhesive tape with a polyester film base having a width of 17 mm was used.

Next, sprocket holes were created in the polyimide film having a width of 300 mm, which were wound up around a roll, using a punching apparatus having a width of 300 mm in accordance with circuit patterns which were arranged with a pitch of 48 mm. The polyimide film where sprocket holes were created was slit into tapes having a width of 48 mm in accordance with the arrangement of the circuit patterns.

After that, the following procedure was repeated with the permanent connection apparatus shown in Fig. 13, and thus, a tape-style flexible circuit board having a length of approximately 40 m and a width of 48 mm was gained.
(a) A portion in a location of temporary connection was punched out by using a mold so that a protruding portion having a width of 3 mm and a length of 12 mm was provided in a pair of spaces for conveyance in an end portion of the polyimide film on the downstream side in the direction of conveyance. The polyimide film on the upstream side was cut in a straight line form along the adhesive layer.
(b) The two divided polyimide films were made to overlap in such a manner that the end portions of the polyimide films in the direction of conveyance overlapped with the entire width in the direction perpendicular to the direction of conveyance. Here, the overlapping portion with the entire width was 0.5 mm in the direction of conveyance, and the gap between the units after the connection was 0.75 mm.
(c) After that, the adhesive layer was heated using a heat and pressure application means 416, and thus, the two polyimide films were connected and fixed to each other. Here, the head of the heat and pressure application means 416 had a width of 3 mm and a length of 12 mm in the location corresponding to a space for conveyance and a surface having a width (length in the direction of conveyance) of 0.5 mm in the location corresponding to the portion between the spaces for conveyance. A pressure of 1 N/mm² was applied at a temperature of 350°C for 10 seconds.

Polyimide films were temporarily connected to each other in a state of being laminated on glasses, and therefore, two polyimide films could be straightly connected without any wrinkles or shrinkage even though the polyimide films were thin sheets and a displacement in the lateral direction in each connection portion was always within 0.1 mm, which was excellent. Furthermore, polyimide films were connected to each other in a state of being stuck on glasses, and after that, were peeled from the glasses and wound up continuously, and therefore, workers intervened only at the time of replacing the winding roll and the unwinding roll, making automatic operation possible during the other operations.

In 500 circuit pattern units on the thus gained tape-style flexible circuit board, the distance between the center lines of 800 wires which were aligned in the direction of the length of 19.975 mm with a pitch of 25 µm in a circuit pattern was measured using a length measuring machine SMIC-800 (made by Sokkia Co., Ltd.), and then, the value was in a range of +/-2 µm of the target value of 19.975 mm, which was excellent. A connection portion in the tape-style flexible circuit board was cut out, and the strength of connection was measured at an atmospheric temperature of 150°C in an apparatus for measurement where a heating unit was added to "Tensilon", made by ORIENTEC Co., LTD, and was found to be 11 N, which was strength sufficient for conveyance in the post processing.

### Example 2

A tape-style flexible circuit board was fabricated in the same manner as in Example 1, except that a resin was applied with a length of 0.4 mm in the direction of conveyance throughout the entire width in the direction perpendicular to the direction of conveyance between spaces for conveyance.

The strength of connection was measured in the same manner as in Example 1 and was found to be 13 N, which was strength sufficient for conveyance in the post processing.

### Example 3

A tape-style flexible circuit board was fabricated in the same manner as in Example 1, except that the temperature of the head of the heat and pressure application means 416 was 200°C.

The strength for connection was measured in the same manner as in Example 1 and was found to be 4.7 N, which was strength that could be used in the post processing. However, there was a concern that the margin was slightly insufficient in the case where a force for intermittent feeding was applied.

### Example 4

Circuit patterns, cover layers and adhesive layers were formed in the same manner as in Example 1. Next, the polyimide film was cut into strips having a width of 48 mm and a length of 350 mm in accordance with the arrangement of the circuit patterns using a YAG laser. By using a glass scribing apparatus, scribe lines were drawn on the glass on the side opposite to the side to which the polyimide film was laminated according to the strips of sheet-style polyimide films, and then, the glass was cut into pieces.

An IC having an outer shape of 22 mm × 2.2 mm and staggered gold bumps with a pitch of 25 µm was bonded to a strip of sheet-style polyimide film stuck on a glass by using an IC bonder (made by TORAY Engineering Co., Ltd.).

The polyimide films to which IC's were bonded were temporarily connected, sprocket holes were created, and then, the polyimide films were permanently connected in the same manner as in Example 1. Here, the conveyance mechanism of the temporary connection apparatus and the punching apparatus was adjusted corresponding to the width of 48 mm, and polyurethane foam was used as the surface of the separating roll of the temporary connection apparatus.

Polyimide films were temporarily connected to each other in a state of being laminated onto glasses, and therefore, two polyimide films could be straightly connected without any wrinkles or shrinkage even though the polyimide films were thin sheets and a displacement in the lateral direction in each connection portion was always within 0.1 mm, which was excellent. Furthermore, polyimide films were connected to each other in a state of being stuck on glasses, and after that, were peeled from the glasses and wound up continuously, and therefore, workers intervened only at the time of replacing the winding roll and the unwinding roll, making automatic operation possible during the other operations.

Folding and curing did not occur to the gained tape-style flexible circuit board when the tape-style circuit board was peeled from the glasses. The strength of connection was 11 N, which was excellent.

### Example 5

A resin for an adhesive layer that was used for the permanent connection was prepared as follows. 24.9 g (0.1 mol) of 1, 1, 3, 3-tetramethyl-1, 3-bis (3-aminopropyl) disiloxane and 180.2 g (0. 9 mol) of 4, 4'-diamino diphenyl ether were put into a reaction pot to which a thermometer, an inlet through which dry nitrogen was introduced, a heating and cooling apparatus using hot water and cold water and a stirring apparatus were provided together with 2813 g of N, N-dimethyl acetamide, and the mixture was dissolved, and after that, 291.3 g (0.99 mol) of 3, 3', 4, 4'-biphenyl tetracarboxylic acid dianhydride was added so that a reaction occurred for one hour at room temperature, and then, for five hours at 70°C, and thus, an adhesive made of 15 wt % of a polyamide acid solution was gained. The adhesive was cured at 280°C for five hours in the same manner as in Example 1, and after that, the Tg of this adhesive was measured in accordance with a TMA (thermal mechanical analysis) method and was found to be 260°C.

Circuit patterns were gained in the same manner as in Example 1, and after that, solder resist SN-9000 (made by Hitachi Chemical Co., Ltd.) was printed using a screen printer and was cured at 120°C for 90 minutes in an oven. Next, the adhesive made of the above described polyamide acid solution was applied to a space for conveyance with a width of 2.8 mm and a length of 2. 4 mm on which the protruding portion of another flexible circuit board was to overlap in the permanent connection and the portion between spaces for conveyance with the entire width in the direction perpendicular to the direction of conveyance and with a length of 0.2 mm in the direction of conveyance using a dispenser. After that, the adhesive was dried at 120°C for 10 minutes so that an adhesive layer having a thickness of 2 µm was gained.

The flexible circuit boards were temporarily connected, sprocket holes were created and the flexible circuit board was cut into slits in the same manner as in Example 1. The following procedure was repeated using the permanent connection apparatus shown in Fig. 13 so that a tape-style flexible circuit board having a length of approximately 40 m and a width of 48 mm was fabricated.
(a) A portion in a location of temporary connection was punched out by using a mold so that a protruding portion having a width of 3 mm and a length of 2.6 mm was provided in a pair of spaces for conveyance in an end portion of the polyimide film on the downstream side in the direction of conveyance. The polyimide film on the upstream side was cut into a straight line form along the adhesive layer.
(b) The two divided polyimide films were made to overlap in such a manner that the end portions of the polyimide films in the direction of conveyance overlapped through the entire width in the direction perpendicular to the direction of conveyance. Here, the overlapping portion throughout the entire width was 0.5 mm in the direction of conveyance, and the gap between the units after the connection was 0.75 mm.
(c) After that, the adhesive layer was heated using a heat and pressure application means 416, and thus, the two polyimide films were connected and fixed each other. Here, the head of the heat and pressure application means 416 had a width of 3 mm and a length of 2.6 mm in the location corresponding to a space for conveyance and a surface having a width of 0.5 mm in the location corresponding to the portion between the spaces for conveyance. A pressure of 1 N/mm² was applied at a temperature of 350°C for 10 seconds.

A connection portion of the thus gained tape-style flexible circuit board was cut out, and the strength of connection was measured in the same manner as in Example 1 and was found to be 30 N, which was a sufficient strength.

### Example 6

A tape-style flexible circuit board was gained by changing the following points from Example 5.

A resin was applied to a space for conveyance with a width of 2.8 mm and a length of 1.8 mm on which the protruding portion of another flexible circuit board overlapped and an area between spaces for conveyance with the entire width in the direction perpendicular to the direction of conveyance and with a length of 0.2 mm in the direction of conveyance. After that, the resin was dried at 120°C for 10 minutes, and thus, an adhesive layer having a thickness of 2 µm was gained.

In addition, a protruding portion having a width of 3 mm and a length of 2 mm was provided in the step (a) of permanent connection. Furthermore, a heat and pressure application means having a head with a width of 3 mm and a length of 2 mm in a location corresponding to the space for conveyance, and a width of 0.5 mm in a location corresponding to the area between spaces for conveyance was used so that a pressure of 1 N/mm² was applied at a temperature of 350°C for 10 seconds in the step (c) of permanent connection.

A connection portion of the thus gained tape-style flexible circuit board was cut out, and the strength of connection was measured in the same manner as in Example 1 and was found to be 26 N, which was a sufficient strength.

### Example 7

A tape-style flexible circuit board was gained in the same manner as in Example 5, except that an adhesive layer was not applied to an area between spaces for conveyance with the entire width in the direction perpendicular to the direction of conveyance.

A connection portion of the gained tape-style flexible circuit board was cut out, and the strength of connection was measured in the same manner as in Example 1 and was found to be 8 N, which was excellent.

Here, gaps in the center portion in the direction of the width of the tape-style flexible circuit board to which an adhesive was not applied sometimes opened during conveyance, and therefore, in the case where a roll having a small diameter was used and the angle for winding was large, there was a slight possibility that the tape-style flexible circuit board might have been caught on a part that was placed in the proximity, causing trouble with the running of the flexible circuit board.

### Comparative Example 1

A long polyimide film ("Kapton"150EN (trade name), made by Dupont-Toray Co., Ltd.) having a thickness of 25 µm was prepared as a base film which formed a flexible circuit board. An alloy layer of chromium and nickel, of which the weight ratio was chromium : nickel = 5 : 95 and a thickness of 15 nm, and a copper layer having a thickness of 150 nm were layered on the polyimide film in this order using a sputtering apparatus for reel-to-reel processing on a long film.

The above described polyimide film to which a metal layer was provided was cut into sheets of 300 mm × 350 mm. One of these sheets of polyimide films was placed on a suction board, and a positive type photoresist was applied to the top of the metal layer using a spin coater, and after that, was dried at 80°C for 10 minutes. The polyimide film to which the photoresist was applied was placed on the suction board of a stepper and was exposed to light through a photomask. This photoresist was developed, and a photoresist layer having a thickness of 12 µm was formed on the portions where a plating layer was unnecessary. The pattern formed on one polyimide film was the same as in Example 1.

As a result of this, six strips of sheet-style flexible circuit boards having the same size as that of the final product were formed in one polyimide film. Here, at this stage, the polyimide film was not yet cut into strips.

Next, a copper layer having a thickness of 8 µm was formed with electroplating in a copper sulfate plating solution using the above described metal layer as an electrode. The photoresist was removed using a photoresist remover, and then, the copper layer and the chromium-nickel alloy layer beneath the resist layer were removed through soft etching using a hydrogen peroxide-sulfuric acid based solution. Subsequently, a tin layer having a thickness of 0.4 µm was formed on the copper plating layer through electroless plating, and thus, a circuit pattern was gained.

After that, a cover layer for protecting the circuit pattern and an adhesive layer for connection were formed simultaneously using a screen printer. The cover layer was formed by applying a resin only onto the top of the circuit pattern and the surroundings thereof. The adhesive layer was formed by applying a resin to a space for conveyance with a width of 2. 8 mm and a length of 11.8 mm on which the protruding portion of another flexible circuit board overlapped in the permanent connection and an area between spaces for conveyance with the entire width in the direction perpendicular to the direction of conveyance and with a length of 0.2 mm in the direction of conveyance.

Solder resist SN-9000 (made by Hitachi Chemical Co., Ltd.) was used for the cover layer and the adhesive layer. In the thus gained 500 circuit pattern units, the distance between the center lines of 800 wires which were aligned in the direction of the length of 19.975 mm with a pitch of 25 µm in a circuit pattern was measured using a length measuring machine SMIC-800 (made by Sokkia Co. , Ltd.), and then, the value was greater than the target value of 19.975 mm by 6 µm at the maximum, which indicated the lack of margin for the connection of an IC with a pitch of 25 µm.

Subsequently, polyimide films on which circuit patterns were formed were aligned on a vacuum suction table and were temporarily connected with an adhesive tape along sides having a length of 300 mm. An adhesive tape with a polyester film base having a width of 17 mm was used. Then, the connected polyimide films were wound up around a winding roll placed near the vacuum suction table.

However, thin sheets of polyimide films were handled in a state where they were not supported by a reinforcing plate, and therefore, it was difficult to automate the process, and the above described polyimide films had to be connected only by manual means. In addition, it was difficult to control the precision in the connection portions, and thus, sometimes displacement in a connection portion in the lateral direction exceeded 0.5 mm, and there was a problem with the conveyance of the polyimide films. Accordingly, the task was ceased at this point in time without carrying out the permanent connection.

### Comparative Example 2

A tape-style flexible circuit board was gained by changing the following points from Example 5.

A protruding portion was not provided to the spaces for conveyance of the polyimide films. Therefore, a resin was applied only in an area with the entire width in the direction perpendicular to the direction of conveyance and with a length of 0.2 mm in the direction of conveyance in the step of forming an adhesive layer in one end portion of a polyimide film on which another flexible circuit board overlapped in the permanent connection. In addition, a heat and pressure application means having a head with a width (direction perpendicular to the direction of conveyance) of 48 mm and a length (direction of conveyance) of 0.5 mm was used so that a pressure of 1 N/mm² was applied at a temperature of 350°C for 10 seconds.

A connection portion was cut out from the thus gained tape-style flexible circuit board, and the strength of connection was measured in the same manner as in Example 1, and then, was found to be 3 N, which was strength insufficient for conveyance in the post processing.

### INDUSTRIAL APPLICABILITY

The circuit board according to the present invention can be appropriately used as a wiring board for an electronic apparatus, an interposer for an IC package and the like.

## Claims

1. A tape-style flexible circuit board, wherein a number of flexible circuit boards where a circuit pattern is formed on at least one surface are connected to each other, the flexible circuit boards have spaces for conveyance in a pair of end portions facing each other, at least a portion of the spaces for conveyance protrudes in the direction parallel to the direction of conveyance of the flexible circuit boards, and the protruding space for conveyance overlaps and is fixed to a space for conveyance of an adjacent flexible circuit board.

2. The tape-style flexible circuit board according to Claim 1, wherein the end portions in the direction of conveyance of said flexible circuit boards overlap and are fixed with the entire width in the direction perpendicular to said direction of conveyance.

3. The tape-style flexible circuit board according to Claim 2, wherein said end portions in the direction of conveyance of the flexible circuit boards overlap the adjacent flexible circuit board with a length of no greater than 1 mm in the direction parallel to said direction of conveyance, excluding said spaces for conveyance.

4. The tape-style flexible circuit board according to any of Claims 1 to 3, wherein said protruding spaces for conveyance overlap the adjacent flexible circuit boards with a length of 1.5 mm to 30 mm in the direction parallel to said direction of conveyance.

5. The tape-style flexible circuit board according to any of Claims 1 to 4, wherein an adhesive layer is provided between said overlapped portions of flexible circuit boards.

6. The tape-style flexible circuit board according to Claim 5, wherein a cover layer for a circuit pattern is formed on said flexible circuit boards, and the cover layer and said adhesive layer have the same composition.

7. A manufacturing method for a tape-style flexible circuit board, comprising: a step of sticking a number of flexible circuit boards on reinforcing plates with removable organic layers; a step of connecting the number of flexible circuit boards to each other; and a step of removing the connected flexible circuit boards from the reinforcing plates.

8. The manufacturing method for a tape-style flexible circuit board according to Claim 7, wherein flexible circuit boards where spaces for conveyance are provided in pairs of end portions facing each other are used, at least a portion of the spaces for conveyance protrudes in the direction parallel to the direction of conveyance of the flexible circuit boards, and the protruding portion overlaps a space for conveyance of an adjacent flexible circuit board, and thereby, the number of flexible circuit boards are connected to each other.

9. The manufacturing method for a tape-style flexible circuit board according to Claim 8, wherein said protruding space for conveyance overlaps a space for conveyance of an adjacent flexible circuit board with a length of 1.5 mm to 30 mm in the direction parallel to said direction of conveyance.

10. The manufacturing method for a tape-style flexible circuit board according to any of Claims 7 to 9, wherein the end portions in the direction of conveyance of said flexible circuit boards overlap the adjacent flexible circuit boards with the entire width in the direction perpendicular to said direction of conveyance.

11. The manufacturing method for a tape-style flexible circuit board according to Claim 10, wherein the end portions in the direction of conveyance of said flexible circuit boards overlap the adjacent flexible circuit boards with a length of no greater than 1 mm in the direction parallel to said direction of conveyance, excluding said spaces for conveyance.

12. The manufacturing method for a tape-style flexible circuit board according to any of Claims 7 to 11, wherein overlapped portions are bonded together with a resin so that said number of flexible circuit boards are connected to each other.

13. The manufacturing method for a tape-style flexible circuit board according to Claim 12, wherein said number of flexible circuit boards are bonded together by heating said resin to a temperature of no lower than the glass transition point of said resin.

14. The manufacturing method for a tape-style flexible circuit board according to any of Claims 7 to 13, wherein flexible circuit boards where a circuit pattern is formed on at least one surface are used.

15. The manufacturing method for a tape-style flexible circuit board according to Claim 14, comprising a step of forming a cover layer on said circuit pattern, wherein an adhesive layer of a resin which has the same composition as said cover layer is formed in a portion with which adjacent flexible circuit boards overlap in the step of forming a cover layer.

16. The manufacturing method for a tape-style flexible circuit board according to Claim 14 or 15, wherein an electronic part is connected to said circuit pattern, and after that, the connected flexible circuit boards are removed from the reinforcing plates.

17. A manufacturing apparatus for a tape-style flexible circuit board, comprising: a connection means for connecting a first flexible circuit board to a second flexible circuit board which is stuck on a reinforcing plate with a removable organic layer; and a winding means for winding the connected flexible circuit boards.

18. The manufacturing apparatus for a tape-style flexible circuit board according to Claim 17, comprising: the conveyance means for conveying a number of the reinforcing plates on which flexible circuit boards are stuck; and a removing means for removing said first flexible circuit board from the reinforcing plate.

19. The manufacturing apparatus for a tape-style flexible circuit board according to Claim 17, wherein said connection means comprises: an overlapping means for making said first flexible circuit board overlap said second flexible circuit board stuck on the reinforcing plate with a resin; and a heat and pressure application means for heating the overlapped flexible circuit boards to a temperature of no lower than the glass transition point of the resin and pressing the overlapped flexible circuit boards.

20. The manufacturing apparatus for a tape-style flexible circuit board according to Claim 19, wherein said heat and pressure application means comprises a heat and press head having a length of no greater than 1 mm in the direction of conveyance of the flexible circuit boards, excluding the portion for heating and pressing a space for conveyance of a flexible circuit board.
